Europäisches Patentamt

European Patent Office

Office européen des brevets

(19)

(11) **EP 1 717 845 A1**

(12) **EUROPEAN PATENT APPLICATION**
published in accordance with Art. 158(3) EPC

(43) Date of publication:
02.11.2006 Bulletin 2006/44

(51) Int Cl.:
*H01L 21/027* (2006.01)    *G03F 7/20* (2006.01)

(21) Application number: 05710323.6

(22) Date of filing: 17.02.2005

(86) International application number:
PCT/JP2005/002473

(87) International publication number:
WO 2005/081293 (01.09.2005 Gazette 2005/35)

(84) Designated Contracting States:
AT BE BG CH CY CZ DE DK EE ES FI FR GB GR
HU IE IS IT LI LT LU MC NL PL PT RO SE SI SK TR

(30) Priority: 19.02.2004 JP 2004042933

(71) Applicant: NIKON CORPORATION
Tokyo 100-8831 (JP)

(72) Inventor: HORIKAWA, Hiroto,
c/o Nikon Corporation
Tokyo (JP)

(74) Representative: HOFFMANN EITLE
Patent- und Rechtsanwälte
Arabellastrasse 4
81925 München (DE)

(54) **EXPOSURE APPARATUS AND EXPOSURE METHOD, AND DEVICE PRODUCING METHOD**

(57)    The present invention provides an exposure apparatus that can satisfactorily perform a measurement process and can accurately perform an exposure process, even if a liquid immersion method is applied to a twin stage type exposure apparatus. An exposure apparatus (EX) comprises: two substrate stages (PST1, PST2) each capable of holding and moving a substrate (P); an exposure station (STE) that exposes, through a projection optical system (PL) and a liquid (LQ), the substrate (P) held by one substrate stage (PST1); and a measuring station (STA) that measures the substrate (P) held by the other substrate stage (PST2) or the abovementioned substrate stage (PST2); and wherein, the measurement performed at the measuring station (STA) is performed in a state wherein the liquid (LQ) is disposed on the substrate stage (PST2) or the substrate (P).

FIG. 1

**Description**

Priority is claimed on Japanese Patent Application No. 2004-42933 (filed February 19, 2004), the contents of which are incorporated herein by reference.

TECHNICAL FIELD

The present invention relates to an exposure apparatus, an exposure method, and a device fabricating method that exposes a substrate through a liquid.

BACKGROUND ART

Semiconductor devices and liquid crystal display devices are fabricated by the so-called photolithography technique that transfers a pattern formed on a mask onto a photosensitive substrate. An exposure apparatus used by this photolithographic process comprises a mask stage that supports the mask, and a substrate stage that supports the substrate, and transfers the pattern of the mask onto the substrate via a projection optical system while successively moving the mask stage and the substrate stage. There has been demand in recent years for higher resolution projection optical systems in order to handle the much higher levels of integration of device patterns. The shorter the exposure wavelength used and the larger the numerical aperture of the projection optical system, the greater the resolution of the projection optical system. Consequently, the exposure wavelength used in exposure apparatuses has shortened year by year and the numerical aperture of projection optical systems has increased. Furthermore, the current mainstream exposure wavelength is the 248 nm KrF excimer laser, but an even shorter wavelength 193 nm ArF excimer laser is also being commercialized. In addition, like resolution, the depth of focus (DOF) is also important when performing an exposure. The following equations respectively express the resolution R and the depth of focus δ.

$$R = k_1 \cdot \lambda / NA, \quad (1)$$

$$\delta = \pm k_2 \cdot \lambda / NA^2, \quad (2)$$

Therein, $\lambda$ is the exposure wavelength, NA is the numerical aperture of the projection optical system, and $k_1$ and $k_2$ are the process coefficients. Equations (1) and (2) teach that shortening the exposure wavelength $\lambda$ increases the resolution R, and that increasing the numerical aperture NA decreases the depth of focus $\delta$.

If the depth of focus $\delta$ becomes excessively small, then it will become difficult to align the surface of the substrate with the image plane of the projection optical system, and there will be a risk of insufficient margin of focus during the exposure operation. Accordingly, a liquid immersion method has been proposed, as disclosed in, for example, PCT International Publication No. WO99/49504 (Patent Document 1), as a method to substantially shorten the exposure wavelength and increase the depth of focus. This liquid immersion method forms an immersion area by filling a liquid, such as water or an organic solvent, between the lower surface of the projection optical system and the surface of the substrate, thus taking advantage of the fact that the wavelength of the exposure light in a liquid is 1/n that of in air (where n is the refractive index of the liquid, normally approximately 1.2 to 1.6), thereby improving the resolution as well as increasing the depth of focus by approximately n times. The disclosures in the Publication (Patent Document 1) are hereby incorporated by reference in its entirety to the extent permitted by the national laws and regulations of the designated states (or elected states) designated by the present international patent application.

DISCLOSURE OF INVENTION

Incidentally, a twin stage type exposure apparatus equipped with two substrate stages for holding substrates has been introduced to the market in recent years. This twin stage type exposure apparatus is a system that prepares for exposure by performing measurement processes, e.g., while an exposure operation is being performed at one substrate stage, the alignment and focus of the next substrate is measured at the other substrate stage. It is vital to ensure that satisfactory measurement processing can be performed even if the liquid immersion method is applied to this twin stage type exposure apparatus.

The present invention considers such circumstances and has an object to provide an exposure apparatus, an exposure method, and a device fabricating method that can satisfactorily perform the measurement process and accurately perform the exposure process, even if the liquid immersion method is applied to a twin stage type exposure apparatus.

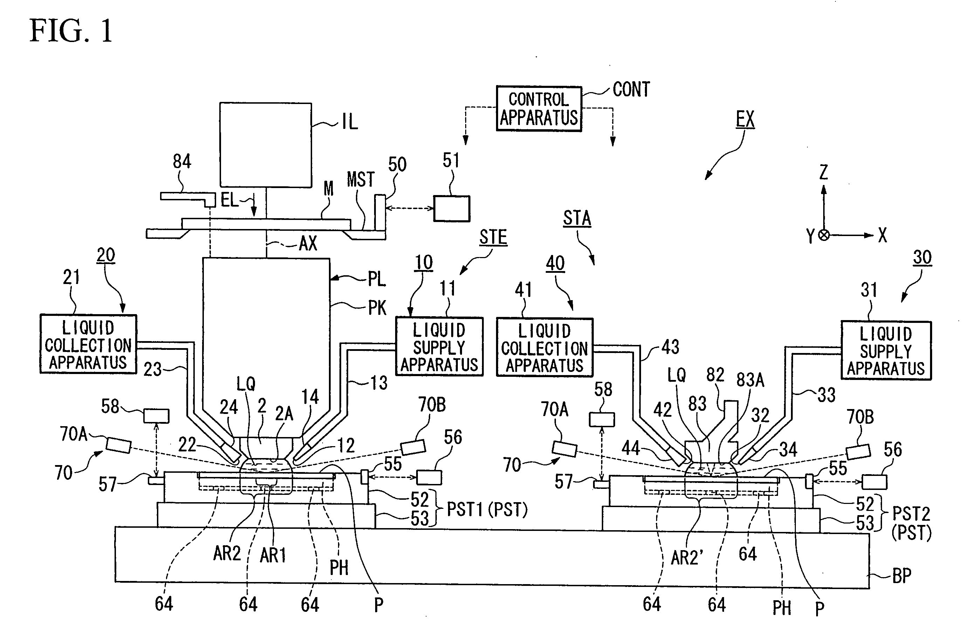

To solve the abovementioned problems, the present invention adopts the following constitution, associated with FIGS. 1 to 7, which depict the embodiments.

An exposure apparatus (EX) of the present invention is an exposure apparatus that exposes a substrate (P) through a liquid (LQ), comprising: at least two substrate stages (PST1, PST2) each capable of holding and moving a substrate (P); an exposure station (STE) that exposes, through an optical system (PL) and the liquid (LQ), a substrate (P) held by one substrate stage (PST1); and a measuring station (STA) that measures the other substrate stage (PST2) or the substrate (P) held by the substrate stage (PST2); wherein, the measurement at the measuring station (STA) is performed in a state wherein the liquid (LQ) has been disposed on the substrate stage (PST2) or on the substrate (P).

In addition, a device fabricating method of the present invention uses the exposure apparatus (EX) as recited above.

According to the present invention, the exposure process is performed at the exposure station in the immersed state (wet state), wherein the liquid is disposed; furthermore, even when performing the measurement process at the measurement station, the measurement process can be performed under substantially the same conditions as the conditions during the exposure process by performing the measurement process in the wet state, wherein the liquid is disposed. Accordingly, it is possible to suppress the generation of measurement errors and to accurately perform the exposure process based on the measurement results thereof.

An exposure method of the present invention is an exposure method that exposes a substrate (P) through a liquid (LQ), comprising the steps of: measuring the substrate stage (PST) or the substrate (P) held by the substrate stage (PST) at the measuring station (STA) in a state wherein the liquid (LQ) is disposed on that substrate stage (PST) or the substrate (P); and exposing, through the optical system (PL) and the liquid (LQ), the substrate (P) at an exposure station separate from the measuring station.

In addition, a device fabricating method of the present invention uses the exposure method as recited above.

According to the present invention, the measurement process can be performed at the measuring station under substantially the same conditions as during the exposure process at the exposure station by performing the measurement process at the measuring station in the wet state, wherein the liquid is disposed. Accordingly, it is possible to suppress the generation of measurement errors and to accurately perform the exposure process based on the measurement results thereof.

In addition, an exposure apparatus of an embodiment different from the one embodiment of the present invention is an exposure apparatus that exposes a substrate (P) through a liquid (LQ), comprising: at least two substrate stages (PST1, PST2) capable of holding and moving a substrate (P); an exposure station (STE) that exposes, through an optical system (PL) and the liquid (LQ), the substrate (P) held by one substrate stage (PST1); a measuring station (STA) that measures the other substrate stage (PST2) or the substrate (P) held by the substrate stage (PST2); a first liquid supply apparatus (10) that supplies the liquid on the substrate (P) held by the substrate stage (PST1) positioned at the exposure station (STE); and a second liquid supply apparatus (30) that supplies the liquid (LQ) on the substrate stage (PST2) or the substrate (P) held by the substrate stage (PST2) positioned at the measuring station (STA).

According to the present invention, while performing an exposure at an exposure station in a wet state, measurement is performed at the measuring station in substantially the same wet state, and the exposure process can therefore be performed accurately based on that measurement result.

BRIEF DESCRIPTION OF THE DRAWINGS

FIG. 1 is a schematic block diagram showing one embodiment of an exposure apparatus of the present invention.

FIG. 2 is a cross sectional view showing a substrate stage.

FIG. 3 is a plan view of the substrate stage viewed from above.

FIG. 4 is a flow chart showing one embodiment of the exposure method of the present invention.

FIG. 5 is a schematic view for explaining an aspect wherein the surface condition of the substrate changes in accordance with the amount of liquid disposed on the substrate.

FIG. 6A and 6B are schematic views for explaining an aspect wherein the surface condition of the substrate changes in accordance with the position of an immersion area.

FIG. 7 is a flow chart showing one example of a process for fabricating a semiconductor device.

BEST MODE FOR CARRYING OUT THE INVENTION

The following explains the exposure apparatus of the present invention, referencing the drawings. FIG. 1 is a schematic block diagram showing one embodiment of the exposure apparatus of the present invention.

In FIG. 1, an exposure apparatus EX is a twin stage type exposure apparatus equipped with two substrate stages, comprising a first substrate stage PST1 and a second substrate stage PST2 on a common base BP, each capable of holding and moving a substrate P and of moving independently. In addition, the twin stage type exposure apparatus EX comprises: an exposure station STE that exposes, through a projection optical system PL and a liquid LQ, a substrate P held by the first substrate stage PST1 (or the second substrate stage PST2); and a measuring station STA that measures the second substrate stage PST2 (or the first substrate stage PST1) or the substrate P held by this substrate stage PST2 (PST1).

The first substrate stage PST1 and the second substrate stage PST2 can be exchanged between the exposure station STE and the measuring station STA by moving them. Furthermore, the substrate P is loaded and unloaded to and from the substrate stage PST1 (PST2) at the measuring station STA. In other words, the substrate P is exchanged at the measuring station STA. Furthermore, while a substrate P is being exposed on one substrate stage PST1 (PST2) disposed at the exposure station STE, either another substrate stage PST2 (PST1) or a substrate P on this substrate stage disposed at the measuring station STA is being measured. Then the substrate stage PST2 (PST1) that held the substrate P for which the measurement process finished at the measuring station STA moves to the exposure station STE. Then, the substrate P on the substrate stage PST2 (PST1) is exposed at the exposure station STE. Meanwhile, the substrate stage PST1 (PST2) that held the substrate P for which the exposure process finished at the exposure station STE moves to the measuring station STA. The substrate P, for which the exposure process finished and that moved to the measuring station STA, is unloaded from the substrate stage PST1 (PST2). Then a new substrate (an unexposed substrate) P is loaded onto the substrate stage PST1 (PST2) and measured. In addition, a control apparatus CONT provides comprehensive supervisory control of the operation of the entire exposure apparatus EX, including the exposure station STE and the measuring station STA. Consequently, the control apparatus CONT is connected to the various measuring means (e.g., an XY interferometer 51, a Z interferometer 58, a focus leveling detection system 70, and load sensors 64A to 64C), drive apparatuses (e.g., a mask stage drive apparatus, a substrate stage drive apparatus, and a Z tilt stage 52), and the like, of the exposure apparatus EX, and is constituted so that it is capable of transmitting measurement results and drive instructions to and from such.

The exposure station STE comprises a mask stage MST that supports a mask M, an illumination optical system IL that illuminates a mask M supported by the mask stage MST with an exposure light EL, and a projection optical system PL that projects a pattern image of the mask M illuminated by the exposure light EL and exposes that pattern image on the substrate P supported by the substrate stage PST1 (PST2).

The exposure apparatus EX of the present embodiment is a liquid immersion type exposure apparatus that applies the liquid immersion method to substantially shorten the exposure wavelength, improve the resolution, and substantially increase the depth of focus. The exposure station STE is provided with a first liquid supply mechanism 10 that supplies a liquid LQ on the substrate P and a first liquid collection mechanism 20 that collects the liquid LQ on the substrate P. The exposure apparatus EX (locally) forms the immersion area AR2, at least during the transfer of the pattern image of the mask M onto the substrate P, by the liquid LQ supplied from the first liquid supply mechanism 10 in one part on the substrate P that includes a projection area AR1 of the projection optical system PL. Specifically, the exposure apparatus EX employs a local immersion method that fills the liquid LQ between an optical element 2 at the image plane side front part of the projection optical system PL and the surface of the substrate P disposed on the image plane side of the projection optical system PL. Furthermore, the exposure apparatus EX projects and exposes the pattern of the mask M onto the substrate P by irradiating the substrate P with the exposure light EL that passed through the mask M, via the projection optical system PL and the liquid LQ, which is between the projection optical system PL and the substrate P.

In addition, the measuring station STA comprises a second liquid supply mechanism 30, which has a constitution substantially equivalent to the first liquid supply mechanism 10, and a second liquid collection mechanism 40, which has a constitution substantially equivalent to the first liquid collection mechanism 20.

As an example, the present embodiment explains a case of using, as the exposure apparatus EX, a scanning type exposure apparatus (a so-called scanning stepper) that, while synchronously moving the mask M and the substrate P in mutually different orientations (reverse directions) in the scanning direction, exposes the substrate P with the pattern formed on the mask M. In the following explanation, the direction that coincides with an optical axis AX of the projection optical system PL is the Z axial direction, the direction in which the mask M and the substrate P synchronously move in the plane perpendicular to the Z axial direction (the scanning direction) is the X axial direction, and the direction perpendicular to the Z axial direction and the X axial direction (the non-scanning direction) is the Y axial direction. In addition, the rotational (inclined) directions around the X, Y, and Z axes are the $\theta X$, $\theta Y$, and $\theta Z$ directions, respectively. Furthermore, "substrate" herein includes one in which a semiconductor wafer is coated with a photoresist, which is a photosensitive material, and "mask" includes a reticle wherein the pattern of a device, which is reduction projected onto the substrate, is formed.

The illumination optical system IL illuminates, with the exposure light EL, the mask M supported by the mask stage MST and comprises: an exposure light source; an optical integrator that uniformizes the intensity of the luminous flux emitted from the exposure light source; a condenser lens that condenses the exposure light EL from the optical integrator; a relay lens system; a variable field stop that sets to a slit shape an illumination region on the mask M illuminated by the exposure light EL; and the like. The illumination optical system IL illuminates the prescribed illumination region on the mask M with the exposure light EL, which has a uniform illumination intensity distribution. Examples of light used as the exposure light EL emitted from the illumination optical system IL include: deep ultraviolet light (DUV light), such as bright lines (g, h, and i lines) in the ultraviolet region emitted from a mercury lamp, for example, and KrF excimer laser light (248 nm wavelength); and vacuum ultraviolet light (VUV light), such as ArF excimer laser light (193 nm wavelength) and $F_2$ laser light (157 nm wavelength). ArF excimer laser light is used in the present embodiment.

The mask stage MST supports the mask M and is two dimensionally movable within a plane perpendicular to the optical axis AX of the projection optical system PL, i.e., within the XY plane, and is micro-rotatable about the θZ direction. The mask stage drive apparatus, such as a linear motor, drives the mask stage MST. The control unit CONT controls the mask stage drive apparatus. A movable mirror 50 is provided on the mask stage MST. In addition, the XY interferometer 51 comprising a laser interferometer is provided at a position opposing the movable mirror 50. The XY interferometer 51 measures in real time the position in the two dimensional direction and the rotational angle of the mask M on the mask stage MST, and outputs the measurement results to the control apparatus CONT. The control apparatus CONT is connected to the XY interferometer 51 and the mask stage drive apparatus, and drives the mask stage drive apparatus based on the measurement results of the XY interferometer 51, thereby positioning the mask M, which is supported by the mask stage MST.

The projection optical system PL, which projects and exposes the pattern of the mask M onto the substrate P with a prescribed projection magnification β, comprises a plurality of optical elements, including the optical element (lens) 2 provided at the terminal end part on the substrate P side (the image plane side of the projection optical system PL), which are supported by a lens barrel PK. In the present embodiment, the projection optical system PL is a reduction system having a projection magnification β of, for example, 1/4 or 1/5. Furthermore, the projection optical system PL may be either a unity magnification system or an enlargement system. In addition, the optical element (lens) 2 of the front part of the projection optical system PL of the present embodiment is attachably and detachably (replaceably) provided to and from the lens barrel PK, and the liquid LQ of the immersion area AR2 contacts the optical element 2.

In the present embodiment, pure water is used as the liquid LQ. Pure water is capable of transmitting not only ArF excimer laser light, but also deep ultraviolet light (DUV light), such as the bright lines (g, h, and i lines) in the ultraviolet region emitted from, for example, a mercury lamp, and KrF excimer laser light (248 nm wavelength).

Furthermore, in the present embodiment, the numerical aperture of the projection optical system, wherein pure water is used for the immersion exposure, is set to at least 1.0 (approximately 1.0 to 1.2).

The optical element 2 is made of fluorite. Because a fluorite surface or a surface to which $MgF_2$, $Al_2O_3$, $SiO_2$, and the like, has been deposited, has a high affinity for water, substantially the entire surface of a liquid contact surface 2A of the optical element 2 can be made to closely contact the liquid LQ. Namely, because the liquid (water) LQ having a high affinity for the liquid contact surface 2A of the optical element 2 is supplied in the present embodiment, the characteristics of close contact between the liquid LQ and the liquid contact surface 2A of the optical element 2 are excellent, and the optical path between the optical element 2 and the substrate P can therefore be reliably filled with the liquid LQ. Furthermore, the optical element 2 may also be made of quartz, which has a high affinity for water. In addition, the liquid contact surface 2A of the optical element 2 may also be treated to make it hydrophilic (lyophilic), thereby improving its affinity for the liquid LQ.

The following explains the substrate stages PST (PST1, PST2) that are each capable of holding and moving the substrate P. Here, the first substrate stage PST1 and the second substrate stage PST2 will be given a generic name and explained as an arbitrary substrate stage PST because the first substrate stage PST1 and the second substrate stage PST2 have substantially equivalent constitutions.

The substrate stage PST is capable of holding and moving the substrate P and comprises the Z tilt stage 52 that holds the substrate P via a substrate holder PH, and an XY stage 53 that supports the Z tilt stage 52. The XY stage 53 (substrate stage PST) is capable of moving on the base BP and between at least the exposure station STE and the measuring station STA.

The substrate stage drive apparatus, such as a linear motor, drives the substrate stage PST. The control apparatus CONT controls the substrate stage drive apparatus. Driving the Z tilt stage 52 controls the position (the focal position) of the substrate P held by the Z tilt stage 52 in the Z axial direction and in the θX, θY directions. In addition, driving the XY stage 53 controls the position of the substrate P in the X and Y directions (the position in a direction substantially parallel to the image plane of the projection optical system PL) and in the θZ direction. In other words, the Z tilt stage 52 controls the focal position and the inclination angle of the substrate P and aligns the surface of the substrate P with the image plane of the projection optical system PL by employing an auto focus system and an auto leveling system; and the XY stage 53 positions (in the X, Y, and θZ directions) the substrate P within the XY plane. Naturally, the Z tilt stage 52 and the XY stage 53 may be integrally provided.

An XY movable mirror 55 is provided on the substrate stage PST (the Z tilt stage 52). In addition, an XY interferometer 56 comprising a laser interferometer is provided at a position opposing the XY movable mirror 55. The XY interferometer 56 measures in real time the position in the two-dimensional directions and the rotational angle (the position information related to the X, Y, and θZ directions) of the substrate stage PST (as well as the substrate P), and outputs the measurement result to the control apparatus CONT. The control apparatus CONT, which is connected to the XY interferometer 56 and the substrate stage drive apparatus, positions the substrate stage PST that held the substrate P by driving the substrate stage drive apparatus based on the measurement result of the XY interferometer 56.

An XY interferometer 56, which is capable of measuring the position in the X and Y directions and the rotational angle of the substrate stage PST, is provided respectively to the exposure station STE and the measuring station STA. Accordingly, the XY interferometer 56 provided to the exposure station STE can measure the position of the substrate stage PST1 (PST2) disposed at the exposure station STE, and the XY interferometer 56 provided to the measuring station STA can measure the position of the substrate stage PST2 (PST1) disposed at the measuring station STA.

In addition, a Z movable mirror 57 is provided on the side surface of the Z tilt stage 52 of the substrate stage PST1, and a Z interferometer 58 is provided at a position opposing the Z movable mirror 57. A Z interferometer 58 is provided respectively to the exposure station STE and the measuring station STA. The Z interferometer 58 measures the substrate stage PST, specifically the position of the Z tilt stage 52 in the Z axial direction.

The exposure station STE and the measuring station STA are respectively provided with a focus leveling detection system 70, which serves as a surface detection system that detects the position information of the surface of the substrate P held by the substrate stage PST. The focus leveling detection system 70 comprises a light projecting part 70A that irradiates the substrate P with the detection light from the inclined direction and a light receiving part 70B that receives the detection light (reflected light) reflected by the substrate P. Furthermore, the system disclosed in, for example, Japanese Unexamined Patent Application, First Publication No. H08-37149 can be used to constitute the focus leveling detection system 70. The detection result of the focus leveling detection system 70 is outputted to the control apparatus CONT. The control apparatus CONT can detect the position information of the surface of the substrate P in the Z axial direction and the inclination information of the substrate P in the θX and the θY directions based on the detection result of the focus leveling detection system 70. The control apparatus CONT, which is connected to the focus leveling detection system 70 and the Z tilt stage 52, uses the auto focus system and the auto leveling system to align the surface of the substrate P with the plane of the image, which is formed through the projection optical system PL and the liquid LQ, by driving the Z tilt stage 52 based on the detection result of the focus leveling detection system 70 and adjusting the position in the Z axial direction (the focal position) and the inclination angle of the substrate P held by the Z tilt stage 52.

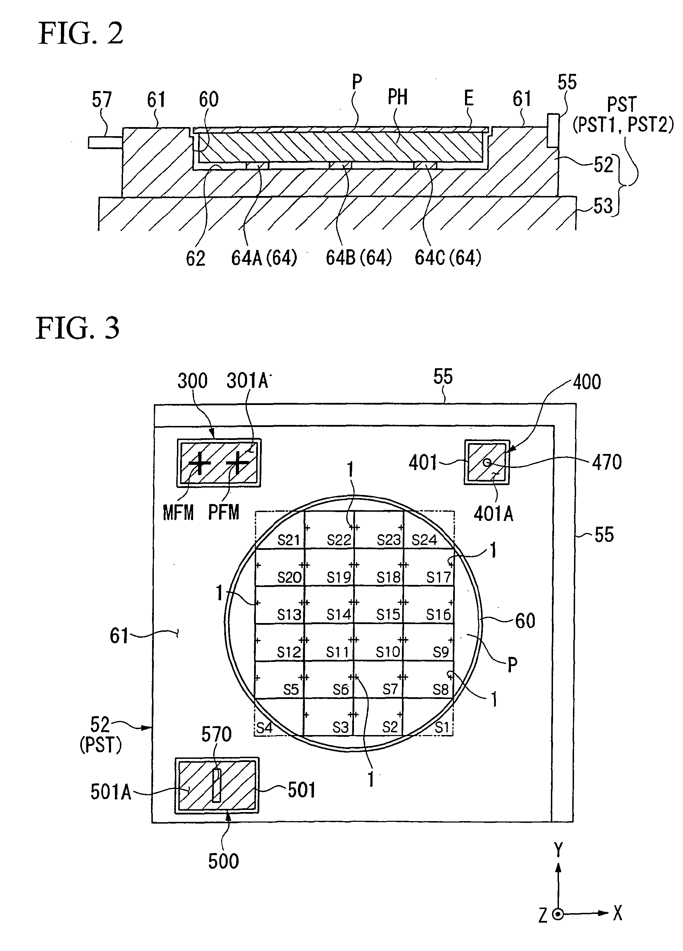

FIG. 2 is an enlarged cross sectional view showing the substrate stage PST (PST1, PST2). The substrate holder PH is disposed in a recessed part 60 provided on the Z tilt stage 52 of the substrate stage PST. Furthermore, an upper surface 61, which is outside of the recessed part 60 of the Z tilt stage 52, is a flat surface (flat part) constituted so that it is substantially the same height as (flush with) the surface of the substrate P held by the substrate holder PH. Consequently, because the upper surface 61 is provided substantially flush with the surface of the substrate P around the circumference of the substrate P, the liquid LQ can be held on the image plane side of the projection optical system PL and the immersion area AR2 can be satisfactorily formed, even when an edge area E of the substrate P is immersion exposed. In addition, there is a gap of approximately 0.1 to 2 mm between the edge part of the substrate P and the upper surface 61 provided around the circumference of the substrate P and, even if exposing the vicinity of the circumferential edge of the substrate P, the upper surface 61 can hold the liquid LQ below the projection optical system PL with hardly any of the liquid LQ flowing into that gap due to the surface tension of the liquid LQ.

In addition, by making the upper surface 61 liquid repellent, it is possible to suppress the outflow of the liquid LQ to the outer side of the substrate P (the outer side of the upper surface 61) during immersion exposure, to smoothly collect the liquid LQ after immersion exposure, and to prevent the liquid LQ from remaining on the upper surface 61, and the like. Furthermore, with the liquid repellency treatment to make the upper surface 61 liquid repellent, it is possible to, for example, apply a coating of a fluororesin material, such as polytetrafluoroethylene, or a liquid repellent material, such as an acrylic resin material, or to affix a thin film made of the abovementioned liquid repellent material. In addition, a material insoluble in the liquid LQ is used as the liquid repellent material for the liquid repellency imparting process.

A plurality of load sensors 64 (64A to 64C) is provided between the lower surface of the substrate holder PH and a bottom surface 62 of the recessed part 60 of the Z tilt stage 52. In the present embodiment, each of the three load sensors 64 comprises, for example, a load cell. The load sensors 64A to 64C measure, via the substrate holder PH, the force applied to the substrate P. The measurement results of the load sensors 64 are outputted to the control apparatus CONT. The control apparatus CONT is connected to the load sensors 64A to 64C, and can derive the force applied to the substrate P and the distribution thereof based on the outputs of the load sensors 64A to 64C. Furthermore, a load sensor may also be provided below the Z tilt stage 52 and the force applied thereto may be measured. In so doing, it is possible to measure, for example, the force applied to the upper surface 61 of the Z tilt stage 52 with the load sensor. In addition, the load sensors 64A to 64C may be provided only below the Z tilt stage 52 without providing them at the lower surface of the substrate holder PH.

Returning to FIG. 1, the first liquid supply mechanism 10 supplies the liquid LQ between the projection optical system PL and the substrate P and comprises: a liquid supply apparatus 11 that comprises a tank that stores the liquid LQ, a pressure pump, and the like; and a supply pipe 13, wherein one end part is connected to the liquid supply apparatus 11 and the other end part is connected to a supply nozzle 14. The supply nozzle 14 comprises a supply port 12 disposed proximate to the substrate P and supplies the liquid LQ from above the substrate P. The liquid LQ, which is fed from the liquid supply apparatus 11 and supplied onto the substrate P via the supply pipe 13 and the supply port 12 of the supply nozzle 14, fills the space between the optical element 2 at the front part of the projection optical system PL and the substrate P, and forms the immersion area AR2.

The first liquid collection mechanism 20 collects the liquid LQ on the substrate P and comprises: a liquid collection apparatus 21 comprising a vacuum system, such as a vacuum pump, a gas-liquid separator, a tank for storing the collected liquid LQ, and the like; and a collection pipe 23, wherein one end part is connected to the liquid collection apparatus 21 and the other end part is connected to a collection nozzle 24. The collection nozzle 24 comprises a collection port 22 disposed proximate to the substrate P and is capable of collecting the liquid LQ on the substrate P. Driving the vacuum system of the liquid collection apparatus 21 sucks and collects the liquid LQ on the substrate P, via the collection port 22 of the collection nozzle 24 and the collection pipe 23, into the liquid collection apparatus 21.

When forming the immersion area AR2 with the liquid LQ on the substrate P, the control apparatus CONT drives the liquid supply apparatus 11 of the first liquid supply mechanism 10, supplies a prescribed quantity of the liquid LQ per unit of time onto the substrate P via the supply pipe 13 and the supply port 12 of the supply nozzle 14, drives the liquid collection apparatus 21 of the first liquid collection mechanism 20, and collects a prescribed quantity of the liquid LQ per unit of time from the substrate P via the collection port 22 of the collection nozzle 24 and the collection pipe 23. Thereby, the liquid LQ is disposed in the space between the optical element 2 at the front part of the projection optical system PL and the substrate P, and the immersion area AR2 is formed.

The measuring station STA is provided with a substrate alignment system 82 that detects the alignment marks on the substrate P or the fiducial mark PFM (discussed later) provided on the Z tilt stage 52. In addition, a mask alignment system 84 that detects a fiducial mark MFM (discussed later) on the Z tilt stage 52, via the mask M and the projection optical system PL, is provided in the vicinity of the mask stage MST of the exposure station STE. In addition, the system disclosed in, for example, Japanese Unexamined Patent Application, First Publication No. H04-65603 can be used for the constitution of the substrate alignment system 82, and the constitution of the mask alignment system 84 is recited in, for example, Japanese Unexamined Patent Application, First Publication No. H07-176468 and the corresponding U.S. Patent No. 5,646,413. The disclosures in the abovementioned publications and U.S. Patent are each hereby incorporated by reference in its entirety to the extent permitted by the national laws and regulations of the designated states (or elected states) designated by the present international patent application.

The measuring station STA is provided with an optical member 83 that comprises a liquid contact surface 83A substantially equivalent to the liquid contact surface 2A of the optical element 2 at the front part of the projection optical system PL. In the present embodiment, the optical member 83 constitutes one part of the optical system of the substrate alignment system 82 and is provided so that it opposes the substrate P on the substrate stage PST.

In addition, the measuring station STA is provided with a second liquid supply mechanism 30 that supplies the liquid LQ between the optical member 83 and the substrate P, and a second liquid collection mechanism 40 that collects the liquid LQ on the substrate P. As discussed above, the second liquid supply mechanism 30 and the second liquid collection mechanism 40 respectively have constitutions substantially the same as the first liquid supply mechanism 10 and the first liquid collection mechanism 20 provided at the exposure station STE. Namely, the second liquid supply mechanism 30 comprises: a liquid supply apparatus 31 that comprises a tank that stores the liquid LQ, a pressure pump, and the like; and a supply pipe 33, wherein one end part is connected to the liquid supply apparatus 31 and the other end part is connected to a supply nozzle 34. The supply nozzle 34 comprises a supply port 32 disposed proximate to the substrate P and supplies the liquid LQ from above the substrate P. The liquid LQ, which is fed by the liquid supply apparatus 31 and supplied via the supply pipe 33 and the supply port 32 of the supply nozzle 34 onto the substrate P, fills the space between the optical member 83 and the substrate P, and thereby forms an immersion area AR2'.

The second liquid collection mechanism 40 collects the liquid LQ on the substrate P and comprises: a liquid collection apparatus 41 that comprises a vacuum system, such as a vacuum pump, a gas-liquid separator, a tank that stores the collected liquid LQ, and the like; and a collection pipe 43 wherein one end part is connected to the liquid collection apparatus 41 and the other end part is connected to a collection nozzle 44. The collection nozzle 44 comprises a collection port 42 disposed proximate to the substrate P and is capable of collecting the liquid LQ on the substrate P. Driving the vacuum system of the liquid collection apparatus 41 sucks and collects the liquid LQ on the substrate P, via the collection pipe 43 and collection port 42 of the collection nozzle 44, into the liquid collection apparatus 41.

The size and shape of the optical member 83 (the liquid contact surface 83A) are substantially the same as the optical element 2 (the liquid contact surface 2A) of the projection optical system PL. In addition, the surface condition of the liquid contact surface 83A is substantially the same as the surface condition of the liquid contact surface 2A. Specifically, the affinity (the contact angle) of the liquid contact surface 83A for the liquid LQ is substantially the same as the affinity (the contact angle) of the liquid contact surface 2A for the liquid LQ. In addition, the distance between the surface of the substrate P (or the upper surface 61) on the substrate stage PST and the liquid contact surface 2A is substantially the same as the distance between the surface of the substrate P (or the upper surface 61) on the substrate stage PST and the liquid contact surface 83A.

Thereby, the control apparatus CONT can form the immersion area AR2 formed at the exposure station STE and the immersion area AR2' formed at the measuring station STA in substantially the same state. Accordingly, the force that the liquid LQ at the exposure station STE exerts upon the substrate P (or the substrate stage PST) can be made substantially the same as the force exerted upon the substrate P (or the substrate stage PST) by the liquid LQ at the measuring station STA.

Here, the following can be cited as forces exerted by the liquid LQ upon the substrate P: the self weight of the liquid LQ; the pressure of the liquid LQ; and the shearing force exerted upon the substrate P by the liquid LQ when the substrate P moves in a state wherein the liquid LQ is filled between the substrate P and the liquid contact surfaces 2A, 83A.

Furthermore, in the present embodiment, the optical member 83 constitutes one part of the substrate alignment system 82, but may be provided independent of the substrate alignment system 82 and constituted so that only the optical member 83 is supported by a prescribed support member. In addition, it is also acceptable if the optical member 83 does not transmit light. In other words, the measuring station STA may be provided with a prescribed member having a liquid contact surface equivalent to the liquid contact surface 2A of the optical element 2 at the front part of the projection optical system PL. In this case, the optical member 83, the abovementioned prescribed member, and the like, each have a liquid contact surface that is equivalent to the optical element (the liquid contact surface 2A) of the projection optical system PL at the exposure station STE, and are constituted so that the immersion area AR2' formed at the measuring station STA and the immersion area AR2 formed at the exposure station STE are formed in substantially the same state, and thereby the optical member 83, the prescribed member, and the like function as dummy members for creating an environment in the measuring station STA that is identical to the environment of the exposure station STE. However, the measurement for alignment can be performed in the state in which the immersion area AR2' is formed by using the optical member 83 for holding the liquid LQ as one part of the optical system of the substrate alignment system 82.

Furthermore, the specific constitution of the twin stage type exposure apparatus is recited in, for example, Japanese Unexamined Patent Application, First Publication Nos. H10-163099 and H10-214783, and the corresponding U.S. Patent No. 6,400,441, and Published Japanese Translation No. 2000-505958 of the PCT International Application and corresponding U.S. Patent Nos. 5,969,441 and 6,262,796. The disclosures in the abovementioned publications and U.S. Patents are each hereby incorporated by reference in its entirety to the extent permitted by the national laws and regulations of the designated states (or elected states) designated by the present international patent application.

FIG. 3 is a plan view of the substrate stage PST (PST1, PST2) viewed from above. In FIG. 3, a movable mirror 55 is disposed at each of two mutually perpendicular edge parts of the substrate stage PST, which is rectangular in a plan view.

In addition, a fiducial member 300 is disposed on the substrate stage PST at a prescribed position on the outer side of the substrate P. The fiducial member 300 is provided with a prescribed positional relationship between the fiducial mark PFM detected by the substrate alignment system 82 and the fiducial mark MFM detected by the mask alignment system 84. An upper surface 301A of the fiducial member 300 is substantially a flat surface and the surface of the substrate P held by the substrate stage PST is provided at substantially the same height as (flush with) the upper surface 61 of the substrate stage PST. The upper surface 301A of the fiducial member 300 can serve the same role as the reference surface of the focus leveling detection system 70.

In addition, the substrate alignment system 82 detects alignment marks 1 formed on the substrate P. As depicted in FIG. 3, a plurality of shot regions S1 to S24 is formed on the substrate P and a plurality of alignment marks 1 is provided on the substrate P corresponding in number to the plurality of shot regions S1 to S24. Furthermore, each shot region is depicted in FIG. 3 so that they are mutually adjacent, but they are actually mutually spaced apart, and the alignment marks 1 are provided on a scribe line, which is an area spaced apart therefrom.

In addition, an illumination intensity nonuniformity sensor 400 of the type disclosed in, for example, Japanese Unexamined Patent Application, First Publication No. S57-117238 and the corresponding U.S. Patent No. 4,465,368 is disposed as a measurement sensor on the substrate stage PST at a prescribed position on the outer side of the substrate P. The illumination intensity nonuniformity sensor 400 comprises an upper plate 401, which is rectangular in a plan view. An upper surface 401 A of the upper plate 401 is substantially a flat surface and is provided at substantially the same height as (flush with) the surface of the substrate P held by the substrate stage PST and the upper surface 61 of the substrate stage PST. A pinhole part 470 capable of passing light therethrough is provided in the upper surface 401 A of the upper plate 401. The upper surface 401 A that is outside of the pinhole part 470 is covered with a shielding material, such as chrome. The disclosures in the abovementioned publication and the U.S. Patent are each hereby incorporated by reference in its entirety to the extent permitted by the national laws and regulations of the designated states (or elected states) designated by the present international patent application.

In addition, an aerial image measuring sensor (AIS: aerial image sensor) 500 of the type disclosed in, for example, Japanese Unexamined Patent Application, First Publication No. 2002-14005 and the corresponding U.S. Patent Application Publication No. 2002/0041377 is provided as a measurement sensor on the substrate stage PST at a prescribed position on the outer side of the substrate P. The aerial image measuring sensor 500 comprises an upper plate 501, which is rectangular in a plan view. An upper surface 501A of the upper plate 501 is substantially a flat surface and is provided at substantially the same height as (flush with) the surface of the substrate P held by the substrate stage PST and the upper surface 61 of the substrate stage PST. A slit part 570 that is capable of passing light therethrough is provided in the upper surface 501 A of the upper plate 501. The upper surface 501A that is outside of the slit part 570 is covered with a shielding material, such as chrome. The disclosures in the abovementioned publications are each hereby incorporated by reference in its entirety to the extent permitted by the national laws and regulations of the designated states (or elected states) designated by the present international patent application.

In addition, although not shown, an irradiation sensor (an illumination intensity sensor) of the type as disclosed in, for example, Japanese Published Patent Application No. H11-16816 and the corresponding U.S. Published Patent Application No. 2002/0061469 is also provided on the substrate stage PST, and an upper surface of an upper plate of that irradiation sensor is provided at substantially the same height as (flush with) the surface of the substrate P held by the substrate stage PST and the upper surface 61 of the substrate stage PST. The disclosures in the abovementioned publications are each hereby incorporated by reference in its entirety to the extent permitted by the national laws and regulations of the designated states (or elected states) designated by the present international patent application.

Furthermore, the fiducial member 300, the upper plates 401, 501, and the like, are detachable from the substrate stage PST. The fiducial member 300, the upper plates 401, 501, and the like, can be replaced when their liquid repellency has deteriorated.

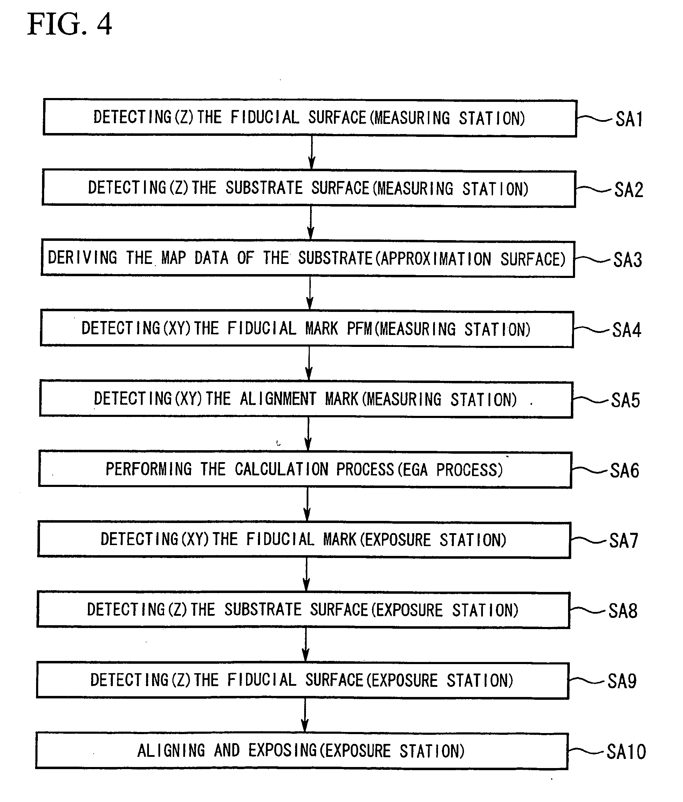

The following explains the procedure for using the exposure apparatus EX that is discussed above to expose the pattern of the mask M onto the substrate P, referencing the flow chart diagram in FIG. 4.

First, before the exposure process, a substrate P is loaded into the measuring station STA. The second substrate stage PST2 is disposed at the measuring station STA and the control apparatus CONT uses a conveyor system (not shown) to load the substrate P before exposure processing onto the second substrate stage PST2 of the measuring station STA. The loaded substrate P is held by the substrate holder PH on the second substrate stage PST2. While, the first substrate stage PST1, which held a substrate P for which the measurement process finished at the measuring station STA, is disposed at the exposure station STE.

Detection of Z Position in the Wet Stage (Measuring Station)

The control apparatus CONT starts the measurement process for the second substrate stage PST2 that holds the substrate P at the measuring station STA. First, the control apparatus CONT moves the substrate stage PST so that it opposes the optical member 83 and the fiducial member 300. Furthermore, the control apparatus CONT uses the second liquid supply mechanism 30 and the second liquid collection mechanism 40 of the measuring station STA to supply and collect the liquid LQ, disposes the liquid LQ between the optical member 83 and the fiducial member 300 on the substrate stage PST disposed at the measuring station STA, and forms the immersion area AR2'. Then, while adjusting the position (the position in the Z direction) and the attitude (the inclinations $\theta X$, $\theta Y$) of the Z tilt stage 52, the control apparatus CONT uses the focus leveling detection system 70 to detect, through the liquid LQ, the position information in the Z axial direction of the surface (upper surface) 301A of the fiducial member 300 on the second substrate stage PST2 (step SA1).

Simultaneous thereto, the control apparatus CONT uses the Z interferometer 58 to detect the position information in the Z axial direction of the Z tilt stage 52. Thereby, the position information of the surface (fiducial surface) 301A of the fiducial member 300 within the coordinate system stipulated by the Z interferometer 58, specifically the position $Z_0$ in the Z axial direction of the second substrate stage PST2 (Z tilt stage 52) when the position of the surface (fiducial surface) 301A of the fiducial member 300 and the focal position of the focus leveling detection system 70 are aligned, is measured by the Z interferometer 58. The information related to the position $Z_0$ is stored in the control apparatus CONT.

Subsequently, the control apparatus CONT opposes the optical member 83 and the substrate P, which is held by the second substrate stage PST2 at the measuring station STA, and supplies and collects the liquid LQ by the second liquid supply mechanism 30 and the second liquid collection mechanism 40, and forms the immersion area AR2' of the liquid LQ on the substrate P. Furthermore, the control apparatus CONT uses the focus leveling detection system 70 provided in the measuring station STA to detect, through the liquid LQ, the position information in the Z axial direction of the plurality of detection points on the surface of the substrate P that is held by the second substrate stage PST2 (step SA2).

For example, while monitoring the output of the XY interferometer 56, the control apparatus CONT moves the XY stage 53 of the second substrate stage PST2 and uses the focus leveling detection system 70 to detect, through the liquid LQ, the position information in the Z direction of the plurality of points within the plane (within the XY plane) of the surface of the substrate P. Specifically, the Z tilt stage 52 is driven while moving the XY stage 53 of the second substrate stage PST2 so that the detection light emitted from the light projecting part 70A of the focus leveling detection system 70 irradiates a plurality of positions on the surface of the substrate P, the position (the position in the Z direction) and the attitude (the inclinations θX, θY) of that Z tilt stage 52 are adjusted, and the Z position information for each of the plurality of points on the surface of the substrate P is detected. The results of the detection of the position information by the focus leveling detection system 70 are stored in the control apparatus CONT associated with the position within the XY plane of the substrate P (second substrate stage PST2). Furthermore, the detection of the position information by the focus leveling detection system 70 may be performed for all of the shot regions S1 to S24 on the substrate P or for only some of the shot regions.

At this point, the control apparatus CONT uses the Z interferometer 58 to measure the Z position information of the Z tilt stage 52 when it has detected, through the liquid LQ and using the focus leveling detection system 70, the position information of the plurality of detection points on the surface of the substrate P. Thereby, the positional relationship between the substrate P and the Z tilt stage 52, as well as the position $Z_0$, can be derived. In other words, the position information of the surface of the substrate P is measured within the coordinate system stipulated by the Z interferometer 58.

Next, the control apparatus CONT prepares map data based on the position information of the plurality of detection points detected on the surface of the substrate P and, based on that map data, derives an approximation plane (approximation surface) of the surface of the substrate P. Thereby, the control apparatus CONT derives the approximation plane of the surface of the substrate P on the basis of the Z tilt stage 52 (position $Z_0$) (step SA3).

Detection of XY Position in the Wet State (Measuring Station)

Subsequently, the control apparatus CONT moves the substrate stage PST so that the detection area of the substrate alignment system 82 is positioned on the fiducial member 300. Specifically, the control apparatus CONT moves the substrate stage PST so that the optical member 83 of the substrate alignment system 82 opposes the fiducial member 300. Furthermore, the control apparatus CONT supplies and collects the liquid LQ using the second liquid supply mechanism 30 and the second liquid collection mechanism 40 and forms the immersion area AR2' of the liquid LQ on the fiducial member 300. In a state wherein the liquid LQ is brought into contact with the liquid contact surface 83A of the optical member 83 and the surface 301 A of the fiducial member 300, the control apparatus CONT uses the substrate alignment system 82 to measure, through the liquid LQ, the fiducial mark PFM on the fiducial member 300. The XY interferometer 56 measures the position of the substrate stage PST when the substrate alignment system 82 is measuring the fiducial mark PFM. Accordingly, the control apparatus CONT can derive the position information of the fiducial mark PFM within the coordinate system specified by the XY interferometer 56 (step SA4).

Next, the control apparatus CONT uses the second liquid supply mechanism 30 and the second liquid collection mechanism 40 of the measuring station STA to supply and collect the liquid LQ, disposes the liquid LQ on the substrate P or on the substrate stage PST disposed at the measuring station STA, and forms the immersion area AR2'. Furthermore, the control apparatus CONT moves the substrate stage PST in the X and Y directions to sequentially dispose, within the detection area of the substrate alignment system 82, the plurality of alignment marks 1 provided on the substrate P and associated with the plurality of shot regions S1 to S24. The control apparatus CONT sequentially measures, through the liquid LQ and using the substrate alignment system 82, the plurality of alignment marks 1 on the substrate P in a state wherein the liquid LQ is disposed on the substrate P and the immersion area AR2' has been formed. At this time, the liquid LQ of the immersion area AR2' is in contact with the liquid contact surface 83A of the optical member 83 of the substrate alignment system 82, and the substrate alignment system 82 measures the alignment marks 1 in a state wherein the liquid LQ has been brought into contact with the liquid contact surface 83A of the optical member 83. The XY interferometer 56 monitors the position of the substrate stage PST when the substrate alignment system 82 is measuring the alignment marks 1. As a result, the control apparatus CONT can derive the position information of each of the alignment marks 1 within the coordinate system stipulated by the XY interferometer 56 (step SA5).

In addition, the substrate alignment system 82 has a detection reference position within the coordinate system stipulated by the XY interferometer 56, and the position information of the alignment marks 1 are detected as a deviation from that detection reference position.

Furthermore, the substrate alignment system 82 of the present embodiment employs a FIA (field image alignment) system that brings the substrate stage PST to rest, irradiates the marks with the illumination light, such as white light, from a halogen lamp, forms the obtained image of the marks within a prescribed image forming field by an imaging device, and performs image processing to measure the positions of the marks.

Here, in the present embodiment, the position information of the shot regions S1 to S24 is derived by a so-called EGA (enhanced global alignment) system of the type disclosed in, for example, Japanese Unexamined Patent Application, First Publication No. S61-44429. Consequently, the control apparatus CONT specifies at least three regions (EGA shot regions) among the plurality of shot regions S1 to S24 formed on the substrate P and uses the substrate alignment system 82 to detect the alignment marks 1 associated with each shot region.

The disclosures in the abovementioned publication are hereby incorporated by reference in its entirety to the extent permitted by the national laws and regulations of the designated states (or elected states) designated by the present international patent application. Furthermore, the substrate alignment system 82 may detect all of the alignment marks 1 on the substrate P.

The control apparatus CONT performs arithmetic processing (EGA process) to derive the position information for each of the shot regions S1 to S24 on the substrate P based on the results of detecting the position information of the alignment marks 1 (step SA6).

With the EGA system, after the position information (coordinate positions) of the alignment marks 1 associated with the abovementioned EGA shot regions has been detected using the substrate alignment system 82, the error parameters (offset, scale, rotation, and orthogonality) related to the array characteristics (position information) of the shot regions S1 to S24 on the substrate P are determined based on those detection values and design values by performing statistical computations by the least squares method, and the like. Furthermore, based on these determined parameter values, the design coordinate values for all shot regions S1 to S24 on the substrate P are compensated. Thereby, the positional relationship between the detection reference position of the substrate alignment system 82 and each of the shot regions on the substrate P placed on the substrate stage PST is determined. Namely, based on the output from the laser interferometer 56, the control apparatus CONT can know where each shot region on the substrate P is positioned with respect to the detection reference position of the substrate alignment system 82.

Here, as depicted in FIG. 1, the detection area of the substrate alignment system 82 of the measuring station STA and the detection area of the focus leveling detection system 70 are provided substantially identical or proximate. Furthermore, the immersion area AR2' can be irradiated simultaneously with both the detection light of the substrate alignment system 82 and the detection light of the focus leveling detection system 70. Namely, both the detection area of the substrate alignment system 82 and the detection area of the focus leveling detection system 70 of the measuring station STA are provided on the inner side of the immersion area AR2'. Accordingly, the control apparatus CONT can substantially simultaneously perform measurement by the substrate alignment system 82 and by the focus leveling detection system 70. Specifically, the abovementioned step SA1 and step SA4 can be performed in parallel. Alternatively, the abovementioned step SA2 and the step SA5 can also be performed in parallel. Thereby, the measurement process time can be reduced.

Furthermore, the detection of the surface information of the substrate P (step SA2) may be performed after the detection of the position information of the plurality of alignment marks 1 has been performed (step SA5). Alternatively, the detection of the surface information of the substrate P and the detection of the position information of the alignment marks 1 may be performed alternately. Alternatively, the detection of the Z position (steps SA1, SA2) may be performed after the detection of the XY position of the marks has been performed (steps SA4, SA5). Namely, the order of each of the steps discussed above can be modified arbitrarily.

Furthermore, based on the position information of the fiducial mark PFM measured in step SA4 and the position information of the plurality of the alignment marks 1 on the substrate P measured in step SA5, the control apparatus CONT can derive the positional relationship between the fiducial.mark PFM and the plurality of alignment marks 1 on the substrate P. In addition, the positional relationship between the plurality of the alignment marks 1 and the shot regions S1 to S24 is derived from the EGA process in step SA6. Accordingly, the control apparatus CONT can derive each of the positional relationships between the fiducial mark PFM and the plurality of the shot regions S1 to S24 on the substrate P based on the positional relationships between the previously derived fiducial mark PFM and the plurality of the alignment marks 1 on the substrate P. In addition, the control apparatus CONT can determine each of the positional relationships in the XY plane between the fiducial mark MFM and the plurality of shot regions S1 to S24 on the substrate P because, as discussed above, it is already known that the fiducial mark PFM and the fiducial mark MFM are provided with a prescribed positional relationship.

The second substrate stage PST2, for which the measurement process (steps SA1 to SA6) at the measuring station STA as discussed above has ended, moves to the exposure station STE. Furthermore, the control apparatus CONT uses the second liquid collection mechanism 40 to collect the liquid LQ on the substrate P and the substrate stage PST before the substrate stage PST moves from the measuring station STA to the exposure station STE. Meanwhile, the first substrate stage PST1, which was disposed at the exposure station STE, moves to the measuring station STA. At this point, the exposure process is performed at the exposure station STE on the substrate P that was held by the first substrate stage PST1 in parallel with the measurement process performed on the second substrate stage PST2 at the measuring station STA.

The first substrate stage PST1, which held the substrate P for which the exposure process finished, moves to the measuring station STA. The substrate P on the first substrate stage PST1, which moved to the measuring station STA, is unloaded. Then, the substrate P to be newly exposure processed is loaded onto the first substrate stage PST1 of the measuring station STA, and the measuring process discussed above is then performed.

Detection of XY Position in the Wet State (Exposure Station)

Meanwhile, the control apparatus CONT uses the mask alignment system 84 to perform the measurement process on the second substrate stage PST2 that moved from the measuring station STA to the exposure station STE. The control apparatus CONT moves the substrate stage PST in the X and Y directions so that the fiducial mark MFM on the fiducial member 300 can be detected by the mask alignment system 84, i.e., so that the optical element 2 at the front part of the projection optical system PL opposes the fiducial member 300. Then, the control apparatus CONT uses the first liquid supply mechanism 10 and the first liquid collection mechanism 20 of the exposure station STE to supply and collect the liquid LQ, and forms the immersion area AR2 by filling the liquid LQ between the optical element 2 of the projection optical system PL and the fiducial member 300. Then, the control apparatus CONT uses the mask alignment system 84 to detect the fiducial mark MFM through the mask M, the projection optical system PL, and the liquid LQ (step SA7).

Namely, the control apparatus CONT detects, through the projection optical system PL and the liquid LQ, the positional relationship between the mark on the mask M and the fiducial mark MFM. Thereby, the positional relationship between the fiducial mark MFM and the position of the mask M within the XY plane, i.e., the projection position information of the image of the pattern of the mask M, is measured through the projection optical system PL and the liquid LQ.

Furthermore, the mask alignment system 84 of the present embodiment employs a VRA (visual reticle alignment) system that detects a mark position by irradiating the mark with light and performing image processing of the image data of the mark imaged by a CCD camera, and the like.

Furthermore, the control apparatus CONT can align the shot regions S1 to S24 on the substrate P and the projection position of the pattern image of the mask M, which passed through projection optical system PL and the liquid LQ, based on: the information of the positional relationship between the fiducial mark PFM that was measured using the abovementioned substrate alignment system 82 and each of the shot regions S1 to S24 on the substrate P; the information of the positional relationship between the projection position of the pattern image of the mask M measured using the abovementioned mask alignment system 84 and the fiducial mark MFM; and the information of the positional relationship between the known fiducial mark PFM, which is provided with a prescribed positional relationship, and the fiducial mark MFM.

Detection of Z Position in the Wet State (Exposure Station)

In addition, after the substrate stage PST has moved so that the optical element 2 of the projection optical system PL opposes the substrate P, the control apparatus CONT supplies and collects the liquid LQ by the first liquid supply mechanism 10 and the first liquid collection mechanism 20 and forms the immersion area AR2 of the liquid LQ on the substrate P.

Then, the control apparatus CONT uses the focus leveling detection system 70 provided in the exposure station STE to detect, through the liquid LQ, the Z position information of one detection point on the surface of the substrate P on the second substrate stage PST2 or detection points numbering less than the detection points that were detected by the measuring station STA (step SA8).

Furthermore, the control apparatus CONT uses the Z interferometer 58 to measure the Z position information of the Z tilt stage 52 when the focus leveling detection system 70 was used to detect the position information of the detection points on the surface of the substrate P. The position in the Z axial direction of the Z tilt stage 52 (position with respect to the position $Z_0$) is detected by the Z interferometer 58. Because the approximation plane of the surface of the substrate P is derived in step SA3, the control apparatus CONT can detect the position information within the XY plane and the Z position information at one or a plurality of detection points on the surface of the substrate P at the exposure station STE and, based on those detection results, can derive the approximation plane of the surface of the substrate P at the exposure station STE using the Z tilt stage 52 as a reference (position $Z_0$).

In addition, in a state wherein the second substrate stage PST2 has moved and the liquid LQ is filled between the optical element 2 of the projection optical system PL and the fiducial member 300, the control apparatus CONT detects with the focus leveling detection system 70 the surface (fiducial surface) 301A of the fiducial member 300 and measures the relationship between the plane of the image, which is formed through the projection optical system PL and the liquid LQ, and the surface 301A of the fiducial member 300 (step SA9).

Here, the focus leveling detection system 70 is constituted so that the positional relationship (deviation) between the surface to be inspected and the plane of the image, which is formed by the projection optical system PL and through the liquid LQ, can be detected in the wet state. Accordingly, by detecting the surface 301A of the fiducial member 300 in the wet state, the focus leveling detection system 70 can derive the positional relationship between the surface of the substrate P and the plane of the image, which is formed through the projection optical system PL and the liquid LQ, using the position $Z_0$ as a reference.

Furthermore, the aerial image measuring sensor 500 may be used to measure the plane of the image that formed through the projection optical system PL and the liquid LQ. In that case, the control apparatus CONT opposes the optical element 2 of the projection optical system PL and the upper surface (reference surface) 501 A of the upper plate 501 of the aerial image measuring sensor 500, fills the liquid LQ between the optical element 2 and the upper surface 501A, and forms the immersion area AR2. In that state, the control apparatus CONT moves the Z tilt stage 52 in the Z axial direction while irradiating the aerial image measuring sensor 500 with the exposure light EL, through the projection optical system PL and the liquid LQ, and uses the aerial image measuring sensor 500 to detect the optimal imaging plane (image plane). Then, using the position $Z_0$ as a reference, the position of the plane of the image, which is formed through the projection optical system PL and the liquid LQ, can be derived by measuring the position of the Z tilt stage 52 with the Z interferometer 58 when the optimal imaging plane has been detected. Accordingly, based thereon, the positional relationship between the plane of the image, which is formed through the projection optical system PL and the liquid LQ, and the surface of the substrate P can be derived.

In addition, before exposing the substrate P, e.g., in a state wherein the liquid LQ has been filled between the optical element 2 of the projection optical system PL and the upper surface 401 A of the upper plate 401 of the illumination intensity nonuniformity sensor 400, the control apparatus CONT can emit the exposure light EL from the illumination optical system IL and can detect the illumination intensity distribution of the exposure light EL in the projection area AR1 by the illumination intensity nonuniformity sensor 400 through the projection optical system PL and the liquid LQ. In a state wherein the immersion area of the liquid LQ has been formed on the upper surface 401 A of the illumination intensity nonuniformity sensor 400, the control apparatus CONT sequentially moves the pinhole part 470 of the illumination intensity nonuniformity sensor 400 to a plurality of positions within the irradiated area (projection area) irradiated with the exposure light EL. The control apparatus CONT appropriately compensates the illumination intensity distribution of the exposure light EL based on the detection result of the illumination intensity nonuniformity sensor 400 so that the illumination intensity distribution of the exposure light EL in the projection area AR1 of the projection optical system PL reaches a desired state. Likewise, the control apparatus CONT uses the irradiation sensor discussed above to measure the illumination intensity of the exposure light EL and appropriately compensates such based on that measurement result.

Alignment and Exposure in the Wet State (Exposure Station)

When the abovementioned measurement process has finished, the control apparatus CONT, in order to expose each of the shot regions S1 to S24 on the substrate P, moves the substrate stage PST while supplying and collecting the liquid LQ by the first liquid supply mechanism 10 and the first liquid collection mechanism 20, and moves the immersion area AR2 under the projection optical system PL onto the substrate P. The substrate stage PST can be moved in the X and Y directions in a state wherein the liquid LQ is held below the projection optical system PL because the upper surface 61 of the substrate stage PST, which includes the fiducial member 300, and the surface of the substrate P are each substantially the same height. Then, each of the shot regions S1 to S24 on the substrate P is scanned and exposed (step SA10) using the variety of information derived during the measurement process discussed earlier.

Then, during the scanning and exposure of each of the shot regions S1 to S24, each of the shot regions S1 to S24 which are on the substrate P, and the mask M are aligned based on the information of the positional relationship between the fiducial mark PFM and each of the shot regions S1 to S20, and the projection position information of the pattern image of the mask M derived using the fiducial mark MFM.

In addition, during the scanning and exposure of each of the shot regions S1 to S24, the exposure is performed while adjusting (compensating) the positional relationship between the surface of the substrate P and the plane of the image, which formed through the projection optical system PL and the liquid LQ, without using the focus leveling detection system 70 of the exposure station STE, based on the information of the positional relationship between the surface (fiducial surface) 301A of the fiducial member 300 and the surface of the substrate P derived at the measuring station STA using the position $Z_0$ as a reference, and the information of the positional relationship between the surface 301A of the fiducial member 300 and the plane of the image, which formed through the projection optical system PL and the liquid LQ, derived at the exposure station STE. In other words, when performing immersion scanning exposure, the Z tilt stage 52 is driven so that the plane of the image, which passed through the projection optical system PL and the liquid LQ and the surface (exposure surface) of the substrate P are coincident, based on the information related to the approximation surface of the surface of the substrate P obtained in steps SA8, SA9 and the information related to the Z position of the plane (surface: fiducial surface) 301A of the fiducial member 300. Thereby, immersion exposure can be performed in a state wherein the attitude (the Z, θX, and θY positions) of the substrate P has been appropriately adjusted with respect to each of the shot regions S1 to S24. Furthermore, if the position information for all shot regions S1 to S24 on the substrate P has been detected in step SA2, then the relationship to the surface 301 A of the fiducial member 300 related to the position in the Z direction is obtained for each shot region. In contrast, if the position information in the Z direction has been detected for just some of the shot regions on the substrate P in step SA2, then the position information of the Z direction at the position within the XY plane corresponding to each shot region may be derived in advance by calculation, and the like, based on the obtained approximation surface (indicated by the X, Y, and Z coordinates).

Furthermore, the surface information (the Z position information within the XY plane) of the surface of the substrate P may be detected using the focus leveling detection system 70 of the exposure station STE during scanning and exposure, and used to confirm the results of adjusting the positional relationship between the surface of the substrate P and the plane of the image, which formed through the liquid LQ.

Furthermore, with the embodiments discussed above, the adjustment of the positional relationship between the surface of the substrate P and the plane of the image, which formed through the liquid LQ, is performed by driving the Z tilt stage 52 that holds the substrate P, but the image plane may be aligned with the surface of the substrate P by moving the mask M, some of the plurality of lenses that constitute the projection optical system PL, and the like.

The control apparatus CONT moves the second substrate stage PST2 of the exposure station STE to the measuring station STA after the immersion exposure process on the substrate P on the second substrate stage PST2 has finished. In parallel, the control apparatus CONT moves the first substrate stage PST1 that held the substrate P, for which the measurement process finished at the measuring station STA, to the exposure station STE.

The control apparatus CONT uses the conveyor system (not shown) to unload the substrate P, which was held by the second substrate stage PST2 that moved to the measuring station STA, and for which the exposure process has finished.

As explained above, if performing an exposure (immersion exposure) in the wet state wherein the liquid LQ is disposed on the substrate P at the exposure station STE of the twin stage type exposure apparatus EX, then the measurement process can be performed based on substantially the same conditions as during the immersion exposure process by measuring in the wet state with the liquid LQ disposed on the substrate P or on the substrate stage PST, even when performing the measurement process at the measuring station STA. Accordingly, it is possible to suppress the generation of measurement errors and to accurately perform the exposure process based on that measurement result.

Namely, when the liquid LQ is disposed on the substrate P, the substrate stage PST, and the like, a force acts upon the substrate P, the substrate stage PST, and the like, due to the pressure, the self weight, and the like, of the liquid LQ, and there is therefore a possibility that the substrate P, the substrate stage PST, and the like, will deform, although only slightly. Consequently, a case arises wherein, for example, the shape of the substrate P (or the substrate stage PST) in the non-immersed state (dry state), wherein the liquid LQ is not disposed, and the shape of the substrate P (or the substrate stage PST) in the immersed state (wet state), wherein the liquid LQ is disposed, are different. Therefore, a situation arises wherein, for example, the measurement result of the surface position information of the substrate P when the measurement was performed in the dry state and the actual surface position of the substrate P when placed in the wet state are different.

Alternatively, a situation also occurs wherein, due to the refractive index of the liquid LQ, the optical path of the detection light when measuring the surface information of the substrate P through the liquid LQ differs from the optical path of the detection light when measuring not through the liquid LQ. If such a situation occurs, it becomes problematic, for example, to align the surface of the substrate P with the plane of the image, which formed through the projection optical system PL and the liquid LQ, if the surface position of the substrate P is adjusted based on the measurement result in the dry state.

Alternately, by performing measurement in the wet state at the measuring station STA and, based on that measurement result, adjusting (compensating) the surface position of the substrate P when exposing the substrate P in the wet state at the exposure station STE, it is possible to reflect the results of the measurement at the measuring station STA in the exposure at the exposure station STE and to dispose the surface position of the substrate P at the desired position.

In addition, in the present embodiment, because the liquid LQ is brought into contact with the liquid contact surface 83A, which is substantially the same as the liquid contact surface 2A of the optical element 2 of the projection optical system PL, when forming the immersion area AR2' at the measuring station STA, the state wherein the immersion area AR2 formed at the exposure station STE can be made substantially the same as the state wherein the immersion area AR2' is formed at the measuring station STA. Accordingly, the accuracy of measurements performed at the measuring station STA can be improved.

In addition, the exposure apparatus EX in the present embodiment is a twin stage type exposure apparatus, and therefore it is possible, by premeasuring the surface position information of the substrate P at the measuring station STA, to efficiently adjust at the exposure station STE, based on that measurement result, the positional relationship between the surface of the substrate P and the plane of the image, which passed through the projection optical system PL and the liquid LQ, and to consequently improve throughput.

Furthermore, in the present embodiment, the approximation plane of the substrate P is derived in advance based on the surface position information of the substrate P measured by the measuring station STA, and, based on that derived result, the Z tilt stage 52 is driven by feedforward control in order to align the surface of the substrate P with the plane of the image that passed through the projection optical system PL and the liquid LQ. Accordingly, even if there were a minute deformation component (high-order deformation component) in the surface of the substrate P, the operation of adjusting the positional relationship by the Z tilt stage 52 can be made to track the deformation component, therefore making it possible to align the surface of the substrate P (the exposure surface) with the plane of the image that formed through the projection optical system PL and the liquid LQ. For example, with a constitution that drives the Z tilt stage 52 by feedback control in order to align the surface of the substrate P with the plane of the image, which formed through the projection optical system PL and the liquid LQ, based on the detection result of the focus leveling detection system 70 provided in the exposure station STE, there may be a limit in the responsiveness (tracking) when driving the Z tilt stage 52 in response to the response frequency of the feedback system, and the like. Nevertheless, it is possible to drive the Z tilt stage 52 with high responsiveness (tracking) by driving the Z tilt stage 52 by feedforward control based on the previously derived approximation plane of the substrate P.

Furthermore, the Z tilt stage 52 may be driven to adjust the positional relationship between the surface of the substrate P and the image plane by detecting the surface information of the surface of the substrate P using the focus leveling detection system 70 of the exposure station STE during scanning exposure and supplementing the approximation plane of the substrate P previously derived by the measuring station STA with the surface information detected during scanning exposure. Namely, the abovementioned feedforward control and feedback control may be used in parallel.

Furthermore, with the present embodiment, the substrate alignment system 82 of the measuring station STA is constituted to measure the alignment marks 1 on the substrate P and the fiducial mark PFM of the fiducial member 300 in the wet state, but it may be constituted to measure the marks in the dry state. By doing so, it is possible to derive the positional relationship between the substrate P and the fiducial mark PFM.

Incidentally, with the present embodiment, when exposing the substrate P at the exposure station STE, the position of the surface of the substrate P is compensated based on the measurement result of the focus leveling detection system 70 of the measuring station STA, but the surface position of the substrate P at the exposure station STE can also be compensated based on the measurement result of the load sensors 64. Here, as discussed above, the load sensors 64A to 64C are provided below the substrate holder PH that holds the substrate P and can measure, via the substrate holder PH, the force exerted by the liquid LQ on the substrate P. Furthermore, the control apparatus CONT can more accurately align the surface of the substrate P with the plane of the image, which formed through the projection optical system PL and the liquid LQ, by also taking into consideration the measurement results of the load sensors 64 in compensating the surface position of the substrate P.

Namely, the embodiments discussed above are constituted to derive the approximation plane of the surface of the substrate P using the position $Z_0$ as a reference by: deriving the approximation plane of the substrate P by measuring the surface position of the substrate P in the wet state at the measuring station STA; and detecting the Z position information of one detection point of the surface of the substrate P at the exposure station STE. In this case, if the force exerted on the substrate P by the liquid LQ of the immersion area AR2' formed at the measuring station STA is substantially the same as the force exerted on the substrate P by the liquid LQ of the immersion area AR2 formed at the exposure station STE, then it is possible to satisfactorily align the surface of the substrate P with the plane of the image that formed through the projection optical system PL and the liquid LQ. Incidentally, a measurement error arises if the force exerted on the substrate P by the liquid LQ of the immersion area AR2' formed at the measuring station STA differs from the force exerted on the substrate P by the liquid LQ of the immersion area AR2 formed at the exposure station STE.

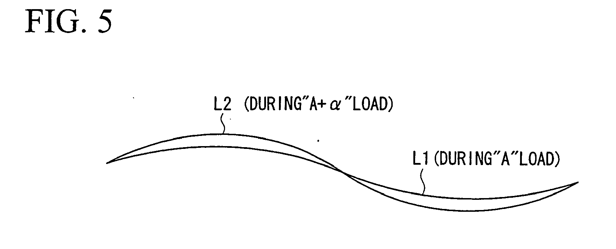

For example, there is a possibility that a situation will arise wherein the amount (weight) of the liquid LQ of the immersion area AR2' formed at the measuring station STA differs from the amount (weight) of the liquid LQ of the immersion area AR2 formed at the exposure station STE, due to variability in the performance of the liquid supply mechanism, the liquid collection mechanism, and the like. For example, if we let A be the amount (weight) of the liquid LQ of the immersion area AR2' formed at the measuring station STA, then the shape of the substrate P becomes shaped as depicted by a line L1 in FIG. 5. However, if we let $A+\alpha$ be the amount (weight) of the liquid LQ of the immersion area AR2 formed at the exposure station STE, then the shape of the substrate P becomes shaped as depicted by a line L2 in FIG. 5. Here, the quantity of deformation of the shape of the substrate P varies substantially proportionate to the weight of the liquid LQ.

In that case, if the position of the surface of the substrate P at the exposure station STE is compensated based on the line L1, which is the approximation plane of the substrate P derived at the measuring station STA, then the actual shape of the substrate P at the exposure station STE is the line L2, and it consequentially becomes problematic to align the surface of the substrate P with the plane of the image that formed through the projection optical system PL and the liquid LQ.

At this point, the control apparatus CONT compensates the surface position of the substrate P at the exposure station STE based on the measurement results of the load sensors 64.

Specifically, the control apparatus CONT uses the load sensors 64A to 64C to measure the force exerted by the liquid LQ on the substrate P in a state wherein the liquid LQ is disposed on the substrate P by the second liquid supply mechanism 30 and the second liquid collection mechanism 40 at the measuring station STA. In addition, the control apparatus CONT uses the focus leveling detection system 70 to measure the shape of the substrate P at that time. Furthermore, the control apparatus CONT stores the load information (load distribution information) measured by the load sensors 64A to 64C associated with the shape information measured using the focus leveling detection systems 70.

Subsequently, the control apparatus CONT moves the substrate stage PST that held the substrate P measured at the measuring station STA to the exposure station STE. Then, the control apparatus CONT uses the load sensors 64A to 64C to measure the force exerted by the liquid LQ on the substrate P in a state wherein the liquid LQ is disposed on the substrate P by the first liquid supply mechanism 10 and the first liquid collection mechanism 20 at the exposure station STE. In addition, the control apparatus CONT uses the focus leveling detection system 70 to measure the Z position information of one detection point of the substrate P at that time.

If we let the measurement result measured using the load sensors 64A to 64C at the measuring station STA be A, the contour of the substrate P measured at that time using the focus leveling detection system 70 be the line L1, and the measurement result measured using the load sensors 64A to 64C at the exposure station STE be $A+\alpha$, then the control apparatus CONT can assume that the shape of the substrate P in the state wherein the liquid LQ is disposed at the exposure station STE is the line L2. Thus, the control apparatus CONT can compensate the approximation plane of the substrate P derived using the focus leveling detection system 70 based on the measurement results of the load sensors 64A to 64C.

Then, the control apparatus CONT determines the compensation quantity related to the drive quantity of the Z tilt stage 52 in order to align the surface of the substrate P, which is the line L2, with the plane of the image that passed through the projection optical system PL and the liquid LQ.

At this point, it is necessary to have information related to the rigidity of the substrate P, the rigidity of the substrate holder PH that holds that substrate P, and the like in order to compensate the approximation plane of the substrate P based on the measurement results of the load sensors 64 at the exposure station STE. That information related to rigidity, and the like, can be derived in advance by, for example, experiments and simulation. For example, it is possible to derive the rigidity of the substrate P, the substrate holder PH, and the like, based on the measurement results of the load sensors 64 when differing amounts of the liquid LQ are respectively disposed on the substrate P, which is held by the substrate holder PH, and the measurement result (the substrate deformation quantity) of the focus leveling detection system 70 at that time, i.e., based on the deformation quantity of the substrate P (substrate holder PH) corresponding to the force exerted by the liquid LQ. Furthermore, by storing that rigidity-related information, the control apparatus CONT can derive the approximation plane of the substrate P at the exposure station STE based on the measurement results of the load sensors 64 at the exposure station STE and on the approximation plane of the substrate P derived at the measuring station STA.

Thus, it is possible to derive the approximation plane of the substrate P based on the measurement result of the focus leveling detection system 70 in a state wherein the liquid LQ is disposed on the substrate P at the measuring station STA, as well as to derive the line L1, which is the first surface information related to the substrate P, by measuring with the load sensors 64 the force exerted upon the substrate P by the liquid LQ at that time; subsequently, it is possible to measure with the load sensors 64 the force exerted upon the substrate P by the liquid LQ in a state wherein the liquid LQ is disposed on the substrate P at the exposure station STE and, based on that measurement result, to derive the line L2, which is the second surface information. Then, based on the line L1 and the line L2, the compensation quantity of the drive quantity of the Z tilt stage 52 is determined in order to compensate the surface position of the substrate P at the exposure station STE. Thereby, the control apparatus CONT can align the surface of the substrate P with the plane of the image, which formed through the projection optical system PL and the liquid LQ, even if the state (weight) of the immersion area AR2' at the measuring station STA and the state (weight) of the immersion area AR2 at the exposure station STE are different.

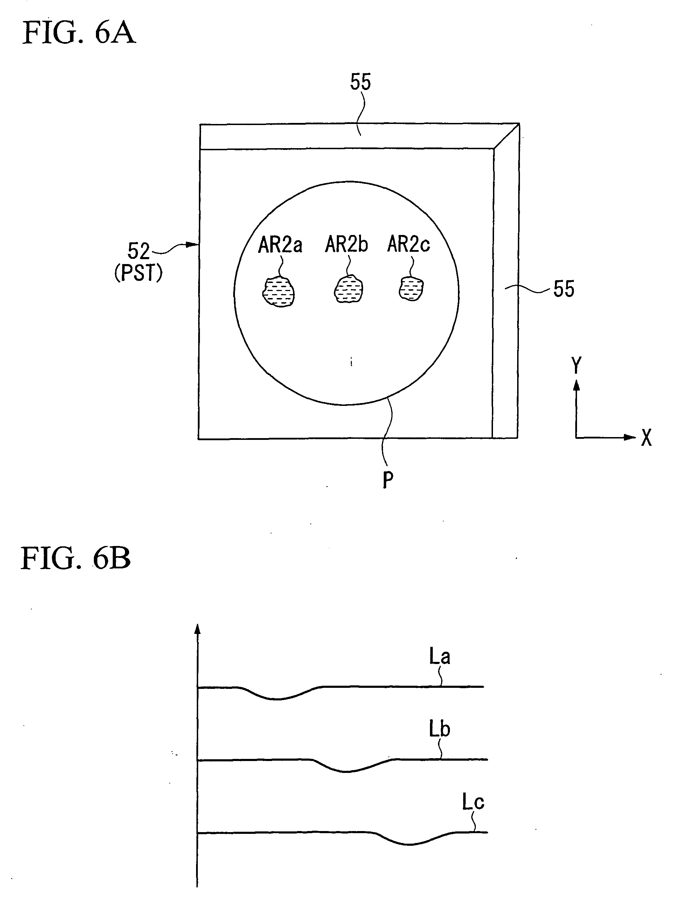

In addition, the present embodiment is constituted to form the immersion area AR2 of the liquid LQ at one part (locally) on the substrate P, and a situation may arise wherein the shape of the substrate P respectively differ depending on the position at which that immersion area AR2 is formed on the substrate P. Namely, as depicted by a symbol AR2a in the schematic view of FIG. 6A, if the immersion area AR2 is formed on the -X side of the substrate P (or the substrate stage PST), then there is a possibility that conspicuous deformation will occur at, for example, the area on the -X side of the substrate P, as depicted by a line La in FIG. 6B. Furthermore, the line La schematically depicts the shape (deformation quantity) of the substrate P. In addition, if the immersion area AR2 is formed at a position like the ones depicted by the symbols AR2b, AR2c in FIG. 6A, then there is a possibility that conspicuous deformation will occur at the position of the substrate P corresponding to the position of that immersion area AR2, as depicted by the lines Lb, Lc in FIG. 6B.

Thus, there is a possibility that the position of the immersion area of the liquid LQ will move, as depicted by the symbols AR2a, AR2b, AR2c, attendant with the movement of the substrate P (substrate stage PST), and that the shape (deformation quantity) of the substrate P, the substrate stage PST, and the like, will change in accordance with the position of the immersion area in the surface direction of the substrate P. It is difficult at this time to measure the global deformation (global contour) of the entire substrate P because the focus leveling detection system 70 is constituted to measure the Z position at a comparatively small area on the substrate P through the liquid LQ of the immersion area AR2 (AR2'). Accordingly, the control apparatus CONT can derive the global deformation (shape) of the entire substrate P based on the measurement results of the load sensors 64A to 64C provided at a plurality of positions. Because the load sensors 64A to 64C are provided at a plurality of positions (three locations), it is possible to measure each load at the plurality of positions (three locations) of the substrate P in a state wherein the liquid LQ is disposed. The output of each of the plurality of load sensors 64A to 64C changes attendant with the movement of the position of the immersion area. By performing prescribed arithmetic processing, the control apparatus CONT can derive the information related to the approximation plane derived using the focus leveling detection system 70, the deformation quantity of the substrate P, including the substrate holder PH, as well as the global deformation (shape) of the entire substrate P based on the measurement results of the load sensors 64A to 64C. At this time, it is possible to derive the global shape of the substrate P based on the measurement results of the load sensors 64 by taking into consideration, for example, the rigidity of the substrate holder PH, the substrate P, and the like.

Furthermore, the present embodiment is constituted so that the load sensors 64A to 64C are provided between the lower surface of the substrate holder PH and the bottom surface 62 of the Z tilt stage 52, but the positions at which load sensors (measuring instruments) are disposed are not limited thereto. For example, a member, such as a glass plate, which transmits the exposure light therethrough, may be disposed between the optical element 2 and the substrate P (substrate holder PH) and, with the immersion exposure method that forms the immersion area AR2 by supplying the liquid LQ between that glass plate and the substrate P, a measuring instrument like the load sensors may be disposed on the glass plate side. Then, the force exerted on the substrate P is measured using that measuring instrument (load sensor). In this case, a member equivalent to the glass plate of the exposure station STE and the measuring instrument, such as a load sensor, are also disposed in advance between the substrate alignment system (first mark detection system) and the substrate P (substrate holder PH) at the measuring station STA. Then, the force exerted upon the substrate P is derived in advance using the measuring instrument (load sensor) in a state wherein the immersion area AR2 is formed by supplying the prescribed liquid between that equivalent member (glass plate) and the substrate P. Furthermore, because the present embodiment is constituted so that the measurement process, prior to performing the exposure process in the immersed state, is also performed in the immersed state, the measurement process is performed under substantially the same conditions as during the exposure process. Incidentally, it is conceivable that the temperature of the substrate P may vary depending on the presence or absence of the liquid on the substrate P, and therefore there is a possibility that the substrate P, the substrate holder PH that holds that substrate P, and the like, may deform. Accordingly, when performing the measurement process, the exposure process, and the like, such may be performed after the immersion areas AR2, AR2' have been formed and the substrate P, the substrate holder PH, and the like, have reached a thermally stable condition after the elapse of a prescribed time period.

In addition, the object to be measured at the measuring station STA is not limited to the present embodiment. Information of a type not directly related to the information related to the position of the fiducial member 300, the substrate P, and the like, disposed on the substrate stage PST, may be measured by, for example, a sensor, which may be built into or detachably attached to the substrate stage PST. For example, information may be measured related to the temperature, the contamination level, and the like, of the liquid LQ.

As discussed above, the liquid LQ in the present embodiment comprises pure water. Pure water is advantageous because it can be easily obtained in large quantities at a semiconductor fabrication plant, and the like, and because pure water has no adverse impact on the optical element (lens), the photoresist on the substrate P, and the like. In addition, because pure water has no adverse impact on the environment and has an extremely low impurity content, it can also be expected to have the effect of cleaning the surface of the substrate P and the surface of the optical element provided on the front surface of the projection optical system PL. Furthermore, the exposure apparatus may be provided with an ultrapure water manufacturing apparatus if the purity of the pure water supplied from the plant, and the like, is low.

Further, the refractive index n of pure water (water) for the exposure light EL having a wavelength of approximately 193 nm is said to be substantially 1.44; therefore, the use of ArF excimer laser light (193 nm wavelength) as the light source of the exposure light EL would shorten the wavelength on the substrate P to 1/n, i.e., approximately 134 nm, thereby obtaining a high resolution. Furthermore, because the depth of focus will increase approximately n times, i.e., approximately 1.44 times, that of in air, the numerical aperture of the projection optical system PL can be further increased if it is preferable to ensure a depth of focus approximately the same as that when used in air, and the resolution is also improved from this standpoint.

Furthermore, the numerical aperture NA of the projection optical system may become 0.9 to 1.3 if the liquid immersion method as discussed above is used. If the numerical aperture NA of such a projection optical system increases, then random polarized light conventionally used as the exposure light will degrade imaging performance due to the polarization effect, and it is therefore preferable to use polarized illumination. In that case, it is better to illuminate with linearly polarized light aligned in the longitudinal direction of the line pattern of the line-and-space pattern of the mask (the reticle), and to emit a large amount of diffracted light of the S polarized light component (the TE polarized light component) i.e., the polarized light direction component aligned in the longitudinal direction of the line pattern, from the pattern of the mask (the reticle). If a liquid is filled between the projection optical system PL and the resist coated on the surface of the substrate P, then the transmittance through the resist surface increases for the diffracted light of the S polarized light component (the TE polarized light component), which contributes to the improvement of the contrast, compared with the case in which air (a gas) is filled between the projection optical system PL and the resist coated on the surface of the substrate P, and a high imaging performance can consequently be obtained even if the numerical aperture NA of the projection optical system exceeds 1.0. In addition, it is further effective to appropriately combine a phase shift mask and the oblique incidence illumination method (particularly the dipole illumination method) aligned in the longitudinal direction of the line pattern, as disclosed in Japanese Unexamined Patent Application, First Publication No. H06-188169. The disclosures in the abovementioned publication are hereby incorporated by reference in its entirety to the extent permitted by the national laws and regulations of the designated states (or elected states) designated by the present international patent application.

In addition, if a fine line-and-space pattern (e.g., a line-and-space of approximately 25 to 50 nm) is exposed on the substrate P using, for example, an ArF excimer laser as the exposure light and using a projection optical system PL having a reduction magnification of approximately 1/4, then the structure of the mask M (e.g., the fineness of the pattern and the thickness of the chrome) causes the mask M to act as a polarizing plate due to the wave guide effect, and a large amount of diffracted light of the S polarized light component (the TE polarized light component) from the diffracted light of the P polarized light component (the TM polarized light component), which decreases contrast, is emitted from the mask M. In this case, it is preferable to use the linear polarized light illumination discussed above; however, even if the mask M is illuminated with random polarized light, a high resolution performance can be obtained even if the numerical aperture NA of the projection optical system PL is as large as 0.9 to 1.3. In addition, if exposing an ultrafine line-and-space pattern of a mask M onto a substrate P, then there is also a possibility that the P polarized light component (the TM polarized light component) will become greater than the S polarized light component (the TE polarized light component) due to the wire grid effect; however, because a greater quantity of diffracted light of the S polarized light component (the TE polarized light component) than the diffracted light of the P polarized light component (the TM polarized light component) is emitted from the mask M if a line-and-space pattern larger than 25 nm is exposed onto the substrate P using, for example, an ArF excimer laser as the exposure light and using a projection optical system PL having a reduction magnification of approximately 1/4, then a high imaging performance can be obtained even if the numerical aperture NA of the projection optical system PL is as large as 0.9 to 1.3.

Furthermore, instead of just linear polarized light illumination (S polarized light illumination) aligned in the longitudinal direction of the line pattern of the mask (the reticle), it is also effective to combine the oblique incidence illumination method with the polarized light illumination method that linearly polarizes light in a direction tangential (circumferential) to a circle with the optical axis at the center, as disclosed in Japanese Unexamined Patent Application, First Publication No. H06-53120. In particular, if the mask (reticle) pattern mixes line patterns extending in a plurality of differing directions instead of a line pattern extending in a prescribed single direction, then by combining the use of the zonal illumination method with the polarized light illumination method that linearly polarizes light in a direction tangential to a circle having the optical axis at its center, as likewise disclosed in Japanese Unexamined Patent Application, First Publication No. H06-53120, it is possible to achieve high imaging performance even if the numerical aperture NA of the projection optical system is large. The disclosures in the abovementioned publications are each hereby incorporated by reference in its entirety to the extent permitted by the national laws and regulations of the designated states (or elected states) designated by the present international patent application.

In the present embodiment, the optical element 2 is affixed at the front of the projection optical system PL and can adjust the optical characteristics of the projection optical system PL, e.g., aberrations (spherical aberration, coma aberration, and the like). Furthermore, the optical element affixed to the front of the projection optical system PL may also be an optical plate used to adjust the optical characteristics of the projection optical system PL. Alternatively, it may be a plane parallel plate capable of transmitting the exposure light EL therethrough.

Furthermore, if high pressure is generated by the flow of the liquid LQ between the substrate P and the optical element at the front of the projection optical system PL, then instead of making the optical element replaceable it may be firmly fixed by that pressure so that it does not move.

Furthermore, the present embodiment is constituted so that the liquid LQ is filled between the projection optical system PL and the surface of the substrate P, but may be constituted so that the liquid LQ is filled in a state wherein, for example, a cover glass comprising a plane parallel plate is affixed to the surface of the substrate P.

Furthermore, although the liquid LQ in the present embodiment is water, it may be a liquid other than water; for example, if the light source of the exposure light EL is an $F_2$ laser, then this $F_2$ laser light will not transmit through water, so it would be acceptable to use as the liquid LQ a fluorine based fluid, such as perfluorinated polyether (PFPE) or fluorine based oil, that is capable of transmitting the $F_2$ laser light. In this case, the portions that make contact with the liquid LQ are treated to make them lyophilic by forming a thin film with a substance having a molecular structure that contains fluorine and that has a small polarity. In addition, it is also possible to use as the liquid LQ one (e.g., cedar oil) that is transparent to the exposure light EL, has the highest possible refractive index, and is stable with respect to the projection optical system PL and the photoresist coated on the surface of the substrate P. In this case, the surface is treated according to the polarity of the liquid LQ used.

Furthermore, the substrate P in each of the abovementioned embodiments is not limited to a semiconductor wafer for fabricating semiconductor devices and is also applicable to a glass substrate for a display device, a ceramic wafer for a thin film magnetic head, or a mask or the original plate of a reticle (synthetic quartz, silicon wafer) used by an exposure apparatus, and the like.

In addition to a step-and-scan system scanning type exposure apparatus (scanning stepper) that scans and exposes the pattern of the mask M by synchronously moving the mask M and the substrate P, a step-and-repeat system projection exposure apparatus (stepper) that exposes the full pattern of the mask M with the mask M and the substrate P in a stationary state and sequentially steps the substrate P is also applicable as the exposure apparatus EX. In addition, the present invention is also applicable to a step-and-stitch system exposure apparatus that partially and superimposingly transfers at least two patterns onto the substrate P.

In addition, the present invention is also applicable to an exposure apparatus that employs a full wafer exposure system that exposes a reduced image of a first pattern onto the substrate P using a projection optical system (e.g., a refraction type projection optical system with a 1/8 reduction magnification and that does not include a reflecting element) in a state wherein the first pattern and the substrate P are substantially stationary. In this case, the present invention can also be applied to a stitching full-wafer exposure apparatus that subsequently further uses that projection optical system to perform a full-wafer exposure of the reduced image of a second pattern, in a state wherein the second pattern and the substrate P are substantially stationary, onto the substrate P, partially overlapping the first pattern.

In addition, in the embodiments discussed above, an exposure apparatus is used that locally fills liquid between the projection optical system PL and the substrate P, but the present invention is also applicable to a liquid immersion exposure apparatus that moves a stage, which holds the substrate to be exposed, in a liquid bath, as well as to a liquid immersion exposure apparatus that forms a liquid pool having a prescribed depth on the stage and holds the substrate therein. The structure and exposure operation of the immersion exposure apparatus that moves the stage that holds the substrate to be exposed in the liquid bath is disclosed in, for example, Japanese Unexamined Patent Application, First Publication No. H06-124873, and the immersion exposure apparatus that forms a liquid pool of a prescribed depth on the stage and holds the substrate therein is disclosed in, for example, Japanese Unexamined Patent Application, First Publication No. H10-303114 and U.S. Patent No. 5,825,043. The disclosures in the abovementioned publications and the U.S. Patent are each hereby incorporated by reference in its entirety to the extent permitted by the national laws and regulations of the designated states (or elected states) designated by the present international patent application.

In addition, the exposure apparatus, wherein the liquid immersion method discussed above is applied, is constituted to fill a liquid (pure water) in the space of the optical path on the emission side of the terminal optical member of the projection optical system PL, and then expose a wafer W (the substrate P), but may be constituted so that it also fills a liquid (pure water) in the space of the optical path on the incident side of the terminal optical member of the projection optical system, as disclosed in the PCT International Publication No. WO2004/019128. The disclosures in the abovementioned publications are hereby incorporated by reference in its entirety to the extent permitted by the national laws and regulations of the designated states (or elected states) designated by the present international patent application.

If these immersion exposure apparatuses are adopted, then they may be respectively constituted so that the measuring station side can be set to the same state as when the wafer at the exposure station is in the exposure state.

The type of exposure apparatus EX is not limited to semiconductor device fabrication exposure apparatuses that expose the pattern of a semiconductor device on the substrate P, but is also widely applicable to exposure apparatuses for fabricating liquid crystal devices or displays, exposure apparatuses for fabricating thin film magnetic heads, imaging devices (CCD), or reticles and masks, and the like.

If a linear motor is used in the substrate stage PST or the mask stage MST (for example, refer to U.S. Patent Nos. 5,623,853 and 5,528,118), then either an air levitation type that uses an air bearing or a magnetic levitation type that uses Lorentz's force or reactance force may be used. In addition, each of the stages PST, MST may be a type that moves along a guide or may be a guideless type not provided with a guide.

For the drive mechanism of each of the stages PST, MST, a planar motor may be used that opposes a magnet unit, wherein magnets are arranged two dimensionally to an armature unit, wherein coils are arranged two dimensionally, and drives each of the stages PST, MST by electromagnetic force. In this case, any one among the magnet unit and the armature unit is connected to the stages PST, MST and the other one of the magnet unit and the armature unit should be provided on the moving surface side of the stages PST, MST.

The reaction force generated by the movement of the substrate stage PST may be mechanically discharged to the floor (ground) using a frame member so that it is not transmitted to the projection optical system PL, as recited in Japanese Unexamined Patent Application, First Publication No. H08-166475 and the corresponding U.S. Patent No. 5,528,118.

The reaction force generated by the movement of the mask (reticle) stage MST may be mechanically discharged to the floor (ground) using a frame member so that it is not transmitted to the projection optical system PL, as recited in Japanese Unexamined Patent Application, First Publication No. H08-330224 and the corresponding U.S. Patent No. 5,874,820. The disclosures in the abovementioned publication and U.S. Patent are each hereby incorporated by reference in its entirety to the extent permitted by the national laws and regulations of the designated states (or elected states) designated by the present international patent application.

In the present embodiment discussed above, a light transmitting type mask that forms a prescribed shielding pattern (or a phase pattern, or a dimming pattern) onto a substrate having light transmitting characteristics, or a light reflection type mask that forms a prescribed reflected pattern onto a substrate having light reflection properties was used, but the present invention is not limited thereto. For example, instead of such a mask, an electronic mask (one type of optical system) may be used that forms a transmittance pattern or a reflected pattern based on digital data of the pattern to be exposed, or that forms a light emitting pattern. Such an electronic mask is disclosed in, for example, U.S. Patent No. 6,778,257. The disclosures in the abovementioned U.S. Patent are each hereby incorporated by reference in its entirety to the extent permitted by the national laws and regulations of the designated states (or elected states) designated by the present international patent application. Furthermore, the electronic mask discussed above is a concept that includes both a non-emissive type image display device and a self luminous type image display device.

In addition, the present invention is also applicable to an exposure apparatus that performs an exposure, which is called a double beam interference exposure, that exposes a substrate with the interference fringes produced by the interference of a plurality of beams. Such an exposure method and an exposure apparatus are disclosed in, for example, PCT International Publication No: WO01/35168. The disclosures in the abovementioned publication are hereby incorporated by reference in its entirety to the extent permitted by the national laws and regulations of the designated states (or elected states) designated by the present international patent application.

The exposure apparatus EX of the embodiments in the present application as described above is manufactured by assembling various subsystems, including each constituent element recited in the claims of the present application, so that a prescribed mechanical accuracy, electrical accuracy, and optical accuracy are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The assembly process from the various subsystems to the exposure apparatus includes the mutual mechanical connection of the various subsystems, the wiring and connection of electrical circuits, the piping and connection of the atmospheric pressure circuit, and the like. Naturally, before the assembly process, ranging from these various subsystems to the exposure apparatus, there are processes for assembling each of the individual subsystems. When the assembly process from various subsystems to the exposure apparatus has completed, a comprehensive adjustment is performed to ensure the various accuracies of the exposure apparatus as a whole. Furthermore, it is preferable to manufacture the exposure apparatus in a clean room wherein the temperature, the cleanliness level, and the like, are controlled.

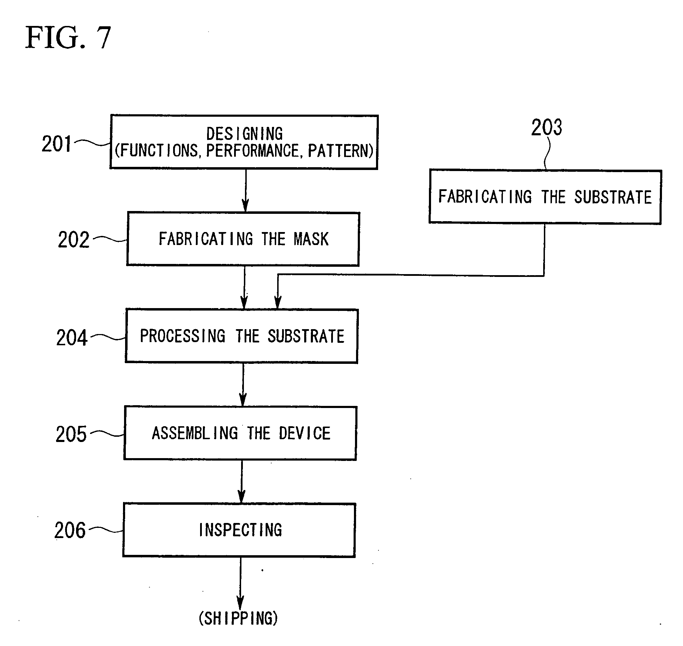

As shown in FIG. 7, a micro-device, such as a semiconductor device is manufactured by: a step 201 that designs the functions and performance of the micro-device; a step 202 that fabricates a mask (reticle) based on this design step; a step 203 that fabricates a substrate, which is the base material of the device; a substrate processing step 204 wherein the exposure apparatus EX of the embodiments discussed above exposes a pattern of the mask onto the substrate; a device assembling step 205 (comprising a dicing process, a bonding process, and a packaging process); an inspecting step 206; and the like.

**Claims**

1. An exposure apparatus that exposes a substrate through a liquid, comprising:

   at least two substrate stages each capable of holding and moving a substrate;
   an exposure station that exposes, through an optical system and the liquid, a substrate held by one substrate stage; and

a measuring station that measures the other substrate stage or the substrate held by said substrate stage; wherein,

the measurement at said measuring station is performed in a state in which the liquid has been disposed on said substrate stage or on said substrate.

2. An exposure apparatus according to claim 1, wherein the measurement at said measuring station is performed during the exposure at said exposure station.

3. An exposure apparatus according to claim 1 or 2, wherein

the substrate on the substrate stage that was measured at said measuring station is exposed at said exposure station;

said measuring station comprises a surface detection system that measures, through the liquid, the surface information of the substrate held by said substrate stage; and

the surface position of the substrate at said exposure station is compensated based on the results of the measurement performed at said measuring station.

4. An exposure apparatus according to any one of claims 1 to 3, wherein

said exposure station comprises a first liquid supply mechanism that supplies the liquid between said optical system and the substrate; and

said measuring station comprises: a dummy member comprising a liquid contact surface substantially equivalent to the liquid contact surface of said optical system; and a second liquid supply mechanism that supplies the liquid between said dummy member and said substrate.

5. An exposure apparatus according to any one of claims 1 to 4, further comprising:

a measuring instrument that measures the force exerted by said liquid upon said substrate or the substrate stage that holds said substrate.

6. An exposure apparatus according to claim 5, wherein the surface position of said substrate at the exposure station is compensated based on the measurement result of said measuring instrument.

7. An exposure apparatus according to claim 6, wherein said measuring instrument comprises a control apparatus that measures the force exerted on said substrate at each of a plurality of positions, in a state in which the liquid has been disposed, and derives the surface information of said substrate based on said measurement result.

8. An exposure apparatus according to claim 6, wherein

a first surface information related to said substrate is derived by performing a measurement, in a state in which the liquid has been disposed on the substrate, with the measuring instrument at said measuring station;

a second surface information related to said substrate is derived by performing a measurement, in a state in which the liquid has been disposed on said substrate, with the measuring instrument at said exposure station; and

a compensation quantity for compensating the surface position of said substrate at said exposure station is determined based on said first surface information and said second surface information.

9. An exposure apparatus according to any one of claims 1 to 8, wherein

a liquid immersion area is formed at one part on said substrate; and

the surface information of said substrate is derived in accordance with the position of said immersion area in the surface direction of said substrate.

10. An exposure apparatus according to any one of claims 1 to 9, wherein said measuring station comprises a first mark detection system that measures, through the liquid, an alignment mark on the substrate held by the substrate stage and also measures, through the liquid, a fiducial mark provided on said substrate stage.

11. An exposure apparatus according to claim 10, wherein

said first mark detection system comprises an optical member comprising a liquid contact surface substantially equivalent to the liquid contact surface of said optical system; and

measurement is performed in a state in which the liquid is brought into contact with the liquid contact surface of said optical member.

12. An exposure apparatus according to claim 10 or 11, wherein said first mark detection system and the surface detection system that measures the surface information of said substrate are capable of performing measurement substantially simultaneously.

13. An exposure apparatus according to any one of claims 10 to 12, wherein

said exposure station comprises a second mark detection system that measures, through the optical system and the liquid, the fiducial mark provided on said substrate stage; and

a shot region on said substrate and the position of a pattern image that passed through said optical system and the liquid are aligned based on the measurement results of said first mark detection system and said second mark detection system.

14. A device fabricating method, wherein the exposure apparatus according to any one of claims 1 to 13 is used.

15. An exposure method that exposes a substrate through a liquid, comprising the steps of:

measuring the substrate stage or the substrate held by said substrate stage at the measuring station in a state in which the liquid is disposed on the substrate stage or the substrate; and exposing, through the optical system and the liquid, said substrate at an exposure station separate from said measuring station.

16. An exposure method according to claim 15, comprising the steps of:

measuring the surface information of said substrate at said measuring station; and exposing the substrate ,while compensating the surface position of the substrate, at said exposure station based on said measurement results.

17. An exposure method according to claim 15 or 16, further comprising the steps of:

measuring, through said optical system and the liquid, the fiducial mark provided on said substrate stage at said exposure station after the alignment mark on the substrate held on said substrate stage at said measuring station has been measured through the liquid, and the fiducial mark provided on said substrate stage has been measured through the liquid; and aligning the shot region on said substrate and the position of the pattern image, which passed through said optical system and the liquid, based on said measurement results.

18. An exposure method according to any one of claims 15 to 17, wherein the measurement at said measuring station is performed during the exposure at said exposure station.

19. A device fabricating method, wherein the exposure method according to any one of claims 15 to 18 is used.

20. An exposure apparatus that exposes a substrate through a liquid, comprising:

at least two substrate stages capable of holding and moving a substrate;

an exposure station that exposes, through an optical system and the liquid, the substrate held by one substrate stage;
a measuring station that measures the other substrate stage or the substrate held by said substrate stage;
a first liquid supply apparatus that supplies the liquid on the substrate held by said substrate stage positioned at said exposure station; and
a second liquid supply apparatus that supplies the liquid on said substrate stage or the substrate held by said substrate stage positioned at said measuring station.

FIG. 1

## FIG. 2

## FIG. 3

# FIG. 4

| | |
|---|---|
| DETECTING(Z) THE FIDUCIAL SURFACE(MEASURING STATION) | SA1 |
| DETECTING(Z) THE SUBSTRATE SURFACE(MEASURING STATION) | SA2 |
| DERIVING THE MAP DATA OF THE SUBSTRATE(APPROXIMATION SURFACE) | SA3 |
| DETECTING(XY) THE FIDUCIAL MARK PFM(MEASURING STATION) | SA4 |
| DETECTING(XY) THE ALIGNMENT MARK(MEASURING STATION) . | SA5 |
| PERFORMING THE CALCULATION PROCESS(EGA PROCESS) | SA6 |
| DETECTING(XY) THE FIDUCIAL MARK(EXPOSURE STATION) | SA7 |
| DETECTING(Z) THE SUBSTRATE SURFACE(EXPOSURE STATION) | SA8 |
| DETECTING(Z) THE FIDUCIAL SURFACE(EXPOSURE STATION) | SA9 |
| ALIGNING AND EXPOSING(EXPOSURE STATION) | SA10 |

# FIG. 5

L2 (DURING"A+$\alpha$"LOAD)

L1 (DURING"A"LOAD)

# FIG. 6A

# FIG. 6B

# FIG. 7

201 — DESIGNING (FUNCTIONS, PERFORMANCE, PATTERN)

203

FABRICATING THE SUBSTRATE

202 — FABRICATING THE MASK

204 — PROCESSING THE SUBSTRATE

205 — ASSEMBLING THE DEVICE

206 — INSPECTING

(SHIPPING)

## INTERNATIONAL SEARCH REPORT

| International application No. |
|---|
| PCT/JP2005/002473 |

**A. CLASSIFICATION OF SUBJECT MATTER**
Int.Cl$^7$ H01L21/027, G03F7/20

According to International Patent Classification (IPC) or to both national classification and IPC

**B. FIELDS SEARCHED**

Minimum documentation searched (classification system followed by classification symbols)
Int.Cl$^7$ H01L21/027, G03F7/20

Documentation searched other than minimum documentation to the extent that such documents are included in the fields searched
Jitsuyo Shinan Koho        1922-1996   Jitsuyo Shinan Toroku Koho    1996-2005
Kokai Jitsuyo Shinan Koho   1971-2005   Toroku Jitsuyo Shinan Koho    1994-2005

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| P,A | WO 2004/053954 A1 (Nikon Corp.),<br>24 June, 2004 (24.06.04),<br>Description; pages 21 to 23; Fig. 6<br>& AU 2003289237 A1      & JP 2004-207710 A | 1-20 |
| P,A | WO 2004/053951 A1 (Nikon Corp.),<br>24 June, 2004 (24.06.04),<br>Mode 2; Fig. 10<br>& AU 2003302831 A1      & JP 2005-026649 A | 1-20 |
| P,A | JP 2005-005713 A (ASML NETHERLANDS BV),<br>06 January, 2005 (06.01.05),<br>Page 1; Par. No. [0042]<br>& EP 1486827 A2      & EP 1489461 A1<br>& US 2005/024609 A1 | 1-20 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13 May, 2005 (13.05.05) | Date of mailing of the international search report<br>31 May, 2005 (31.05.05) |
|---|---|
| Name and mailing address of the ISA/<br>Japanese Patent Office | Authorized officer |
| Facsimile No. | Telephone No. |

Form PCT/ISA/210 (second sheet) (January 2004)

## INTERNATIONAL SEARCH REPORT

| International application No. |
| --- |
| PCT/JP2005/002473 |

C (Continuation).   DOCUMENTS CONSIDERED TO BE RELEVANT

| Category* | Citation of document, with indication, where appropriate, of the relevant passages | Relevant to claim No. |
| --- | --- | --- |
| P,A | JP 2004-247548 A  (Nikon Corp.),<br>02 September, 2004 (02.09.04),<br>Page 1, Claims<br>(Family: none) | 1-20 |
| E,A | WO 2005/015615 A1  (Nikon Corp.),<br>17 February, 2005 (17.02.05),<br>Page 1<br>(Family: none) | 1-20 |
| E,A | JP 2005-086030 A  (Canon Inc.),<br>31 March, 2005 (31.03.05),<br>Page 1, Claims<br>& US 2005/052632 A1 | 1-20 |

Form PCT/ISA/210 (continuation of second sheet) (January 2004)

EP 1 717 845 A1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004042933 A
- WO 9949504 A
- JP H0837149 A
- JP H0465603 A
- JP H07176468 A
- US 5646413 A
- JP H10163099 A
- JP H10214783 A
- US 6400441 B
- JP 2000505958 A
- US 5969441 A
- US 6262796 B
- JP 57117238 A
- US 4465368 A
- JP 2002014005 A
- US 20020041377 A

- JP H1116816 B
- US 20020061469 A
- JP 61044429 A
- JP H06188169 A
- JP H0653120 A
- JP H06124873 A
- JP H10303114 A
- US 5825043 A
- WO 2004019128 A
- US 5623853 A
- US 5528118 A
- JP H08166475 A
- JP H08330224 A
- US 5874820 A
- US 6778257 B
- WO 0135168 A